# EUROPÄISCHE PATENTSCHRIFT

(11) **EP 2 181 172 B1**
(45) Veröffentlichungstag und Bekanntmachung des Hinweises auf die Patenterteilung: **24.02.2016**
(21) Anmeldenummer: 08787184.4
(22) Anmeldetag: 13.08.2008
(51) Int. Cl.: C09K 11/06, C09B 5/62, H01L 51/05

(54) **HALOGENHALTIGE PERYLENTETRACARBONSÄUREDERIVATE UND DEREN VERWENDUNG**
HALOGEN-CONTAINING PERYLENETETRACARBOXYLIC ACID DERIVATIVES AND THE USE THEREOF
DÉRIVÉS HALOGÉNÉS D'ACIDE TÉTRACARBOXYLIQUE DE PÉRYLÈNE, ET LEUR UTILISATION

(30) Priorität: 17.08.2007 EP 07114556
(43) Veröffentlichungstag der Anmeldung: 05.05.2010
(73) Patentinhaber: BASF SE, 67056 Ludwigshafen (DE)
(72) Erfinder: KÖNEMANN, Martin, 68199 Mannheim (DE); MATTERN, Gabriele, 67015 Schifferstadt (DE); WEBER, Gerd, 67098 Bad Dürkheim (DE)
(86) Internationale Anmeldenummer: PCT/EP2008/060633
(87) Internationale Veröffentlichungsnummer: WO 2009/024512

(56) Entgegenhaltungen:
- EP-A- 0 698 649
- WO-A-2005/076815
- DE-A1- 4 327 273
- M. SADRAI ET.AL.: "A charge-transfer complex of benzene with a highly twisted perylene derivative" ACTA CRYST., Bd. C46, 1990, Seiten 637-640, XP002501244
- F. WÜRTHNER ET.AL.: "Tetrachloro-substituted perylene bisimide dyes as promising n-type organic semiconductors: studies on structural. electrochemical and charge transport properties" CHEM. PHYS. CHEM., Bd. 5, 2004, Seiten 137-140, XP002501245

## Beschreibung

Die vorliegende Erfindung betrifft perhalogenierte, speziell chlorierte oder fluorierte, Perylentetracarbonsäure-Derivate und deren Verwendung als Emittermaterialien, Ladungstransportmaterialien oder Excitonentransportmaterialien.

Es wird erwartet, dass zukünftig in vielen Bereichen der Elektronikindustrie neben den klassischen anorganischen Halbleitern zunehmend auch organische Halbleiter auf Basis von niedermolekularen oder polymeren Materialien eingesetzt werden. Diese weisen vielfach Vorteile gegenüber den klassischen anorganischen Halbleitern auf, beispielsweise eine bessere Substratkompatibilität und eine bessere Verarbeitbarkeit der auf ihnen basierenden Halbleiterbauteile. Sie erlauben die Verarbeitung auf flexiblen Substraten und ermöglichen es, ihre Grenzorbitalenergien mit den Methoden des Molecular Modellings auf den jeweiligen Anwendungsbereich genau anzupassen. Die deutlich verringerten Kosten derartiger Bauteile haben dem Forschungsgebiet der organischen Elektronik eine Renaissance gebracht. Die "Organische Elektronik" beschäftigt sich schwerpunktmäßig mit der Entwicklung neuer Materialien und Fertigungsprozesse für die Herstellung elektronischer Bauelemente auf der Basis organischer Halbleiterschichten. Dazu zählen vor allem organische Feldeffekttransistoren (Organic Field-Effect Transistors, OFET) sowie organische Leuchtdioden (organische lichtemittierende Dioden, organic light emitting diods, OLED) und die Photovoltaik. Organischen Feldeffekttransistoren wird ein großes Entwicklungspotential, beispielsweise in Speicherelementen und integrierten optoelektronischen Vorrichtungen zugeschrieben. In organischen lichtemittierenden Dioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigeren Stromverbrauchs eignen sich Vorrichtungen, die OLEDs enthalten, insbesondere für mobile Anwendungen, zum Beispiel für Anwendungen in Mobiltelefonen, Laptops usw. Ein großes Entwicklungspotential wird auch Materialien zugeschrieben, die möglichst große Transportweiten und hohe Mobilitäten für lichtinduzierte angeregte Zustände (hohe Excitonendiffusionslängen) besitzen und die sich somit vorteilhaft für einen Einsatz als aktives Material in so genannten excitonischen Solarzellen eignen. Mit Solarzellen auf Basis solcher Materialien lassen sich in der Regel sehr gute Quantenausbeuten erzielen.

Es besteht daher ein großer Bedarf an organischen Verbindungen, die sich als Emittermaterialien, Ladungstransportmaterialien oder Excitonentransportmaterialien eignen.

Die am Prioritätstag dieser Anmeldung unveröffentlichte PCT/EP 2007/051532 (WO2007/093643) beschreibt die Verwendung von Verbindungen der allgemeinen Formel (B) 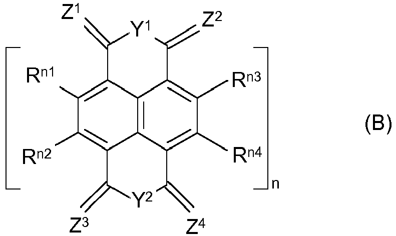 wobei
- n: für 2, 3 oder 4 steht,
wenigstens einer der Reste Rⁿ¹, Rⁿ², Rⁿ³ und Rⁿ⁴ für Fluor steht,
gegebenenfalls wenigstens ein weiterer Rest Rⁿ¹, Rⁿ², Rⁿ³ und Rⁿ⁴ für einen Substituenten steht, der unabhängig ausgewählt ist unter Cl und Br, und die übrigen Reste für Wasserstoff stehen,
- Y¹: für O oder NR^{a} steht, wobei R^{a} für Wasserstoff oder einen Organylrest steht,
- Y²: für O oder NR^{b} steht, wobei R^{b} für Wasserstoff oder einen Organylrest steht,
- Z¹, Z², Z³ und Z⁴: für O stehen,
wobei für den Fall, dass Y¹ für NR^{a} steht, auch einer der Reste Z¹ und Z² für NR^{c} stehen kann, wobei die Reste R^{a} und R^{c} gemeinsam für eine verbrückende Gruppe mit 2 bis 5 Atomen zwischen den flankierenden Bindungen stehen, und
wobei für den Fall, dass Y² für NR^{b} steht, auch einer der Reste Z³ und Z⁴ für NR^{d} stehen kann, wobei die Reste R^{b} und R^{d} gemeinsam für eine verbrückende Gruppe mit 2 bis 5 Atomen zwischen den flankierenden Bindungen stehen,

als Halbleiter, insbesondere n-Halbleiter, in der organischen Elektronik, insbesondere für organische Feldeffekttransistoren, Solarzellen und organische Leuchtdioden.

WO 2005/076815 offenbart Perylenbis(carboximid)-Verbindungen, die elektronenziehende Resten tragen, als n-Typ Halbleiter-Verbindungen. Perylenbis(carboximid)-Verbindungen, die am Kern perfluoriert oder perchloriert sind, sind nicht konkret offenbart.

F. Würthner, Chem. Phys. Chem., Bd. 5, 2004, Seiten 137-140 offenbart Tetrachlorperylenbis(carboximid)-Verbindungen, die an den Imidstickstoffatomen Alkylreste oder mit Alkylgruppen substituierte Phenylreste tragen, als potentielle n-Typ Halbleiter-Verbindungen.

EP 0 689 649 offenbart am Kern tetrasubstituierte Perylenbis(carboximid)-Verbindungen als Fluoreszenzfarbstoffe.

Perylenamidinimid-Farbstoffe sind aus DE 43 27 273 bekannt.

H. J. Schugar (Acta Cryst. (1990), C46, 637 - 640) beschreibt N,N'-Dimethyloctachlorperylen-3,4:9,10-tetracarbonsäurediimid, die potentielle Verwendung dieser Verbindung in Solarzellen, sowie die Herstellung dieser Verbindung durch Chlorierung von N,N'-Dimethylperylen-3,4:9,10-tetracarbonsäurediimid.

Überraschenderweise wurde nun gefunden, dass perhalogenierte Perylentetracarbonsäure-Derivate der im Folgenden beschriebenen Formeln (I.A), (I.Ba), (I.Bb1) und (I.Bb2) besonders vorteilhaft als Emittermaterialien, Ladungstransportmaterialien oder Excitonentransportmaterialien eignen. Sie zeichnen sich dabei insbesondere als luftstabile n-Halbleiter mit außerordentlich hohen Ladungsmobilitäten aus. Weiterhin besitzen sie vorteilhafte Eigenschaften für die Verwendung in excitonischen Solarzellen.

Ein erster Gegenstand der vorliegenden Erfindung betrifft Verbindungen der allgemeinen Formel (I.A) 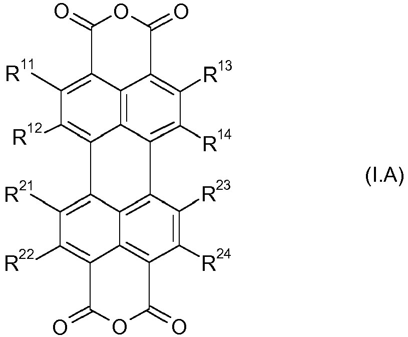 worin R¹¹, R¹², R¹³, R¹⁴, R²¹, R²², R²³ und R²⁴ alle für Fluor stehen.

Ein weiterer Gegenstand der vorliegenden Erfindung betrifft Verbindungen der Formel (I.Ba) 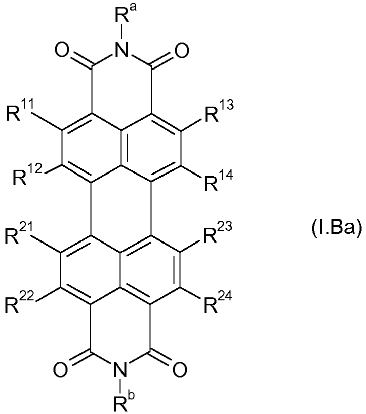 worin R^{a}, R^{b}, R¹¹, R¹², R¹³, R¹⁴, R²¹, R²², R²³ und R²⁴ eine der in Anspruch 1 gegebenen Bedeutungen aufweisen.

Ein weiterer Gegenstand der vorliegenden Erfindung betrifft Verbindungen der Formeln (I.Bb1) und (I.Bb2) 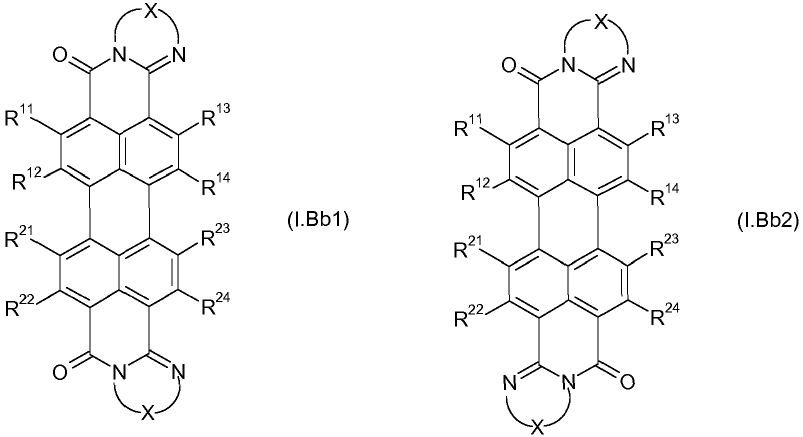 worin R¹¹, R¹², R¹³, R¹⁴, R²¹, R²², R²³, R²⁴ und X eine der in Anspruch 1 gegebenen Bedeutungen aufweisen.

Ein weiterer Gegenstand der Erfindung betrifft die Verwendung der Verbindungen der Formeln (I.A), (I.Ba), (I.Bb1) und (I.Bb2) als Emittermaterialien, Ladungstransportmaterialien oder Excitonentransportmaterialien.

Im Rahmen der vorliegenden Erfindung umfasst der Ausdruck "Alkyl" geradkettiges oder verzweigtes Alkyl. Vorzugsweise handelt es sich um geradkettiges oder verzweigtes C₁-C₃₀-Alkyl, insbesondere um C₁-C₂₀-Alkyl und ganz besonders bevorzugt C₁-C₁₂-Alkyl. Beispiele für Alkylgruppen sind insbesondere Methyl, Ethyl, n-Propyl, Isopropyl, n-Butyl, Isobutyl, sec.-Butyl, tert.-Butyl, n-Pentyl, n-Hexyl, n-Heptyl, n-Octyl, n-Nonyl, n-Decyl, n-Undecyl, n-Dodecyl, n-Tridecyl, n-Tetradecyl, n-Hexadecyl, n-Octadecyl und n-Eicosyl.

Der Ausdruck Alkyl umfasst auch Alkylreste, deren Kohlenstoffketten durch eine oder mehrere nicht benachbarte Gruppen, die ausgewählt sind unter-O-, -S-, -NR^{f}-, -C(=O)-, -S(=O)- und/oder -S(=O)₂- unterbrochen sein kann. R^{f} steht vorzugsweise für Wasserstoff, Alkyl, Cycloalkyl, Heterocycloalkyl, Aryl oder Hetaryl. Der Ausdruck Alkyl umfasst auch substituierte Alkylreste. Substituierte Alkylgruppen können in Abhängigkeit von der Länge der Alkylkette einen oder mehrere (z. B. 1, 2, 3, 4, 5 oder mehr als 5) Substituenten aufweisen. Diese sind vorzugsweise unabhängig voneinander ausgewählt unter Cycloalkyl, Heterocycloalkyl, Aryl, Hetaryl, Halogen, Hydroxy, Mercapto, COOH, Carboxylat, SO₃H, Sulfonat, NE¹E², Nitro und Cyano, wobei E¹ und E² unabhängig voneinander für Wasserstoff, Alkyl, Cycloalkyl, Heterocycloalkyl, Aryl oder Hetaryl stehen. Halogensubstituenten sind vorzugsweise Fluor, Chlor oder Brom. Carboxylat und Sulfonat stehen für ein Derivat einer Carbonsäurefunktion bzw. einer Sulfonsäurefunktion, insbesondere für ein Metallcarboxylat oder -sulfonat, eine Carbonsäureester- oder Sulfonsäureesterfunktion oder eine Carbonsäure- oder Sulfonsäureamidfunktion. Cycloalkyl-, Heterocycloalkyl-, Aryl- und Hetarylsubstituenten der Alkyl-gruppen können ihrerseits unsubstituiert oder substituiert sein; geeignete Substituenten sind die nachfolgend für diese Gruppen genannten.

Die vorstehenden Ausführungen zu Alkyl gelten auch für die Alkylteile in Alkoxy, Alkyl-amino, Alkylthio, Alkylsulfinyl, Alkylsulfonyl, etc.

Durch Aryl substituierte Alkylreste ("Arylalkyl") weisen wenigstens eine, wie nachfolgend definierte, unsubstituierte oder substituierte Arylgruppe auf. Dabei kann die Alkylgruppe in "Arylalkyl" wenigstens einen weiteren Substituenten tragen und/oder durch eine oder mehrere nicht benachbarte Gruppen, die ausgewählt sind unter -O-, -S-, -NR^{f}-, -CO- und/oder -SO₂- unterbrochen sein. R^{f} weist die zuvor genannten Bedeutungen auf. Arylalkyl steht vorzugsweise für Phenyl-C₁-C₁₀-alkyl, besonders bevorzugt für Phenyl-C₁-C₄-alkyl, z. B. für Benzyl, 1-Phenethyl, 2-Phenethyl, 1-Phenprop-1-yl, 2-Phenprop-1-yl, 3-Phenprop-1-yl, 1-Phenbut-1-yl, 2-Phenbut-1-yl, 3-Phenbut-1-yl, 4-Phenbut-1-yl, 1-Phenbut-2-yl, 2-Phenbut-2-yl, 3-Phenbut-2-yl, 4-Phenbut-2-yl, 1-(Phenmeth)-eth-1-yl, 1-(Phenmethyl)-1-(methyl)-eth-1-yl oder-(Phenmethyl)-1-(methyl)-prop-1-yl; vorzugsweise für Benzyl und 2-Phenethyl.

Der Ausdruck "Alkenyl" umfasst im Sinne der vorliegenden Erfindung geradkettige und verzweigte Alkenylgruppen, die in Abhängigkeit von der Kettenlänge eine oder mehrere Doppelbindungen (z. B. 1, 2, 3, 4 oder mehr als 4) tragen können. Bevorzugt sind C₂-C₁₈-, besonders bevorzugt C₂-C₁₂-Alkenylgruppen. Geradkettige oder verzweigte Alkenylgruppen mit zwei Doppelbindungen werden im Folgenden auch als Alkadienyl bezeichnet. Der Ausdruck "Alkenyl" umfasst auch substituierte Alkenylgruppen, welche einen oder mehrere (z. B. 1, 2, 3, 4 5 oder mehr als 5) Substituenten tragen können. Geeignete Substituenten sind z. B. ausgewählt unter Cycloalkyl, Heterocycloalkyl, Aryl, Hetaryl, Halogen, Hydroxy, Mercapto, COOH, Carboxylat, SO₃H, Sulfonat, NE³E⁴, Nitro und Cyano, wobei E³ und E⁴ unabhängig voneinander für Wasserstoff, Alkyl, Cycloalkyl, Heterocycloalkyl, Aryl oder Hetaryl stehen.

Alkenyl steht dann beispielsweise für Ethenyl, 1-Propenyl, 2-Propenyl, 1-Butenyl, 2-Butenyl, 3-Butenyl, 1-Pentenyl, 2-Pentenyl, 3-Pentenyl, 4-Pentenyl, 1-Hexenyl, 2-Hexenyl, 3-Hexenyl, 4-Hexenyl, 5-Hexenyl, Penta-1,3-dien-1-yl, Hexa-1,4-dien-1-yl, Hexa-1,4-dien-3-yl, Hexa-1,4-dien-6-yl, Hexa-1,5-dien-1-yl, Hexa-1,5-dien-3-yl, Hexa-1,5-dien-4-yl, Hepta-1,4-dien-1-yl, Hepta-1,4-dien-3-yl, Hepta-1,4-dien-6-yl, Hepta-1,4-dien-7-yl, Hepta-1,5-dien-1-yl, Hepta-1,5-dien-3-yl, Hepta-1,5-dien-4-yl, Hepta-1,5-dien-7-yl, Hepta-1,6-dien-1-yl, Hepta-1,6-dien-3-yl, Hepta-1,6-dien-4-yl, Hepta-1,6-dien-5-yl, Hepta-1,6-dien-2-yl, Octa-1,4-dien-1-yl, Octa-1,4-dien-2-yl, Octa-1,4-dien-3-yl, Octa-1,4-dien-6-yl, Octa-1,4-dien-7-yl, Octa-1,5-dien-1-yl, Octa-1,5-dien-3-yl, Octa-1,5-dien-4-yl, Octa-1,5-dien-7-yl, Octa-1,6-dien-1-yl, Octa-1,6-dien-3-yl, Octa-1,6-dien-4-yl, Octa-1,6-dien-5-yl, Octa-1,6-dien-2-yl, Deca-1,4-dienyl, Deca-1,5-dienyl, Deca-1,6-dienyl, Deca-1,7-dienyl, Deca-1,8-dienyl, Deca-2,5-dienyl, Deca-2,6-dienyl, Deca-2,7-dienyl, Deca-2,8-dienyl und dergleichen. Die Ausführungen zu Alkenyl gelten auch für die Alkenylgruppen in Alkenyloxy, Alkenylthio, etc.

Der Ausdruck "Alkinyl" umfasst unsubstituierte oder substituierte Alkinylgruppen, die eine oder mehrere nicht benachbarte Dreifachbindungen aufweisen, wie Ethinyl, 1-Propinyl, 2-Propinyl, 1-Butinyl, 2-Butinyl, 3-Butinyl, 1-Pentinyl, 2-Pentinyl, 3-Pentinyl, 4-Pentinyl, 1-Hexinyl, 2-Hexinyl, 3-Hexinyl, 4-Hexinyl, 5-Hexinyl, und dergleichen. Die Ausführungen zu Alkinyl gelten auch für die Alkinylgruppen in Alkinyloxy, Alkinylthio, etc. Substituierte Alkinyle tragen vorzugsweise einen oder mehrere (z. B. 1, 2, 3, 4, 5 oder mehr als 5) der zuvor für Alkyl genannten Substituenten.

Der Ausdruck "Cycloalkyl" umfasst im Rahmen der vorliegenden Erfindung unsubstituierte als auch substituierte Cycloalkylgruppen, vorzugsweise C₃-C₈-Cycloalkylgruppen wie Cyclopropyl, Cyclobutyl, Cyclopentyl, Cyclohexyl, Cycloheptyl oder Cyclooctyl, insbesondere C₅-C₈-Cycloalkyl. Substituierte Cycloalkylgruppen können einen oder mehrere (z. B. 1, 2, 3, 4, 5 oder mehr als 5) Substituenten aufweisen. Diese sind vorzugsweise unabhängig voneinander ausgewählt unter Alkyl sowie den zuvor für die Alkylgruppen genannten Substituenten. Die Cycloalkylgruppen tragen im Falle einer Substitution vorzugsweise eine oder mehrere, beispielsweise eine, zwei, drei, vier oder fünf C₁-C₆-Alkylgruppen.

Beispiele für bevorzugte Cycloalkylgruppen sind Cyclopentyl, 2- und 3-Methylcyclopentyl, 2- und 3-Ethylcyclopentyl, Cyclohexyl, 2-, 3- und 4-Methylcyclohexyl, 2-, 3-und 4-Ethylcyclohexyl, 3- und 4-Propylcyclohexyl, 3- und 4-lsopropylcyclohexyl, 3- und 4-Butylcyclohexyl, 3- und 4-sec.-Butylcyclohexyl, 3- und 4-tert.-Butylcyclohexyl, Cycloheptyl, 2-, 3- und 4-Methylcycloheptyl, 2-, 3- und 4-Ethylcycloheptyl, 3- und 4-Propylcycloheptyl, 3- und 4-Isopropylcycloheptyl, 3- und 4-Butylcycloheptyl, 3- und 4-sec.-Butylcycloheptyl, 3- und 4-tert.-Butylcycloheptyl, Cyclooctyl, 2-, 3-, 4- und 5-Methyl-cyclooctyl, 2-, 3-, 4- und 5-Ethylcyclooctyl, 3-, 4- und 5-Propylcyclooctyl.

Der Ausdruck Cycloalkenyl umfasst unsubstituierte und substituierte einfach ungesättigte Kohlenwasserstoffgruppen mit 3 bis 8, vorzugsweise 5 bis 6 Kohlenstoffringgliedern, wie Cyclopenten-1-yl, Cyclopenten-3-yl, Cyclohexen-1-yl, Cyclohexen-3-yl, Cyclohexen-4-yl und dergleichen. Geeignete Substituenten sind die zuvor für Cycloalkyl genannten.

Der Ausdruck Bicycloalkyl umfasst vorzugsweise bicyclische Kohlenwasserstoffreste mit 5 bis 10 C-Atomen wie Bicyclo[2.2.1]hept-1-yl, Bicyclo[2.2.1]hept-2-yl, Bicyclo[2.2.1]hept-7-yl, Bicyclo[2.2.2]oct-1-yl, Bicyclo[2.2.2]oct-2-yl, Bicyclo[3.3.0]octyl, Bicyclo[4.4.0]decyl und dergleichen.

Der Ausdruck "Aryl" umfasst im Rahmen der vorliegenden Erfindung ein- oder mehrkernige aromatische Kohlenwasserstoffreste, die unsubstituiert oder substituiert sein können. Aryl steht vorzugsweise für unsubstituiertes oder substituiertes Phenyl, Naphthyl, Indenyl, Fluorenyl, Anthracenyl, Phenanthrenyl, Naphthacenyl, Chrysenyl, Pyrenyl, etc., und besonders bevorzugt für Phenyl oder Naphthyl. Substituierte Aryle können in Abhängigkeit von der Anzahl und Größe ihrer Ringsysteme einen oder mehrere (z. B. 1, 2, 3, 4, 5 oder mehr als 5) Substituenten aufweisen. Diese sind vorzugsweise unabhängig voneinander ausgewählt unter Alkyl, Alkoxy, Cycloalkyl, Heterocycloalkyl, Aryl, Hetaryl, Halogen, Hydroxy, Mercapto, COOH, Carboxylat, SO₃H, Sulfonat, NE⁵E⁶, Nitro und Cyano, wobei E⁵ und E⁶ unabhängig voneinander für Wasserstoff, Alkyl, Cycloalkyl, Heterocycloalkyl, Aryl oder Hetaryl stehen. Halogensubstituenten sind vorzugsweise Fluor, Chlor oder Brom. Besonders bevorzugt steht Aryl für Phenyl, das im Falle einer Substitution im Allgemeinen 1, 2, 3, 4 oder 5, vorzugsweise 1, 2 oder 3 Substituenten tragen kann. Diese sind vorzugsweise unabhängig voneinander ausgewählt unter Alkyl sowie den zuvor für die Alkylgruppen genannten Substituenten.

Aryl, das einen oder mehrere Reste trägt, steht beispielsweise für 2-, 3- und 4-Methylphenyl, 2,4-, 2,5-, 3,5- und 2,6-Dimethylphenyl, 2,4,6-Trimethylphenyl, 2-, 3-und 4-Ethylphenyl, 2,4-, 2,5-, 3,5- und 2,6-Diethylphenyl, 2,4,6-Triethylphenyl, 2-, 3-und 4-Propylphenyl, 2,4-, 2,5-, 3,5- und 2,6- Dipropylphenyl, 2,4,6-Tripropylphenyl, 2-, 3- und 4-Isopropylphenyl, 2,4-, 2,5-, 3,5- und 2,6-Diisopropylphenyl, 2,4,6-Triisopropylphenyl, 2-, 3- und 4-Butylphenyl, 2,4-, 2,5-, 3,5- und 2,6-Dibutylphenyl, 2,4,6-Tributylphenyl, 2-, 3- und 4-Isobutylphenyl, 2,4-, 2,5-, 3,5- und 2,6-Diisobutylphenyl, 2,4,6-Triisobutylphenyl, 2-, 3- und 4-sec-Butylphenyl, 2,4-, 2,5-, 3,5- und 2,6-Di-sec-butylphenyl, 2,4,6-Tri-sec-butylphenyl, 2-, 3- und 4-tert.-Butylphenyl, 2,4-, 2,5-, 3,5- und 2,6-Di-tert.-butylphenyl und 2,4,6-Tri-tert.-butylphenyl; 2-, 3-und 4-Methoxyphenyl, 2,4-, 2,5-, 3,5- und 2,6-Dimethoxyphenyl, 2,4,6-Trimethoxyphenyl, 2-, 3- und 4-Ethoxyphenyl, 2,4-, 2,5-, 3,5- und 2,6-Diethoxyphenyl, 2,4,6-Triethoxyphenyl, 2-, 3- und 4-Propoxyphenyl, 2,4-, 2,5-, 3,5- und 2,6-Dipropoxyphenyl, 2-, 3- und 4-lsopropoxyphenyl, 2,4-, 2,5-, 3,5- und 2,6-Diisopropoxyphenyl und 2-, 3- und 4-Butoxyphenyl; 2-, 3- und 4-Cyanophenyl.

Der Ausdruck "Heterocycloalkyl" umfasst im Rahmen der vorliegenden Erfindung nichtaromatische, ungesättigte oder vollständig gesättigte, cycloaliphatische Gruppen mit im Allgemeinen 5 bis 8 Ringatomen, vorzugsweise 5- oder 6 Ringatomen, in denen 1, 2 oder 3 der Ringkohlenstoffatome durch Heteroatome, ausgewählt unter Sauerstoff, Stickstoff, Schwefel und einer Gruppe -NR^{f}- ersetzt sind und das unsubstituiert ist oder mit einer oder mehreren, beispielsweise 1, 2, 3, 4, 5 oder 6 C₁-C₆-Alkylgruppen substituiert ist. R^{f} steht vorzugsweise für Wasserstoff, Alkyl, Cycloalkyl, Heterocycloalkyl, Aryl oder Hetaryl. Beispielhaft für solche heterocycloaliphatischen Gruppen seien Pyrrolidinyl, Piperidinyl, 2,2,6,6-Tetramethyl-piperidinyl, Imidazolidinyl, Pyrazolidinyl, Oxazolidinyl, Morpholidinyl, Thiazolidinyl, Isothiazolidinyl, Isoxazolidinyl, Piperazinyl, Tetrahydrothiophenyl, Dihydrothien-2-yl, Tetrahydrofuranyl, Dihydrofuran-2-yl, Tetrahydropyranyl, 1,2-Oxazolin-5-yl, 1,3-Oxazolin-2-yl und Dioxanyl genannt.

Der Ausdruck "Heteroaryl" umfasst im Rahmen der vorliegenden Erfindung unsubstituierte oder substituierte, heteroaromatische, ein- oder mehrkernige Gruppen, vorzugsweise die Gruppen Pyridyl, Chinolinyl, Acridinyl, Pyridazinyl, Pyrimidinyl, Pyrazinyl, Pyrrolyl, Imidazolyl, Pyrazolyl, Indolyl, Purinyl, Indazolyl, Benzotriazolyl, 1,2,3-Triazolyl, 1,3,4-Triazolyl und Carbazolyl, wobei diese heterocycloaromatischen Gruppen im Falle einer Substitution im Allgemeinen 1, 2 oder 3 Substituenten, tragen können. Die Substituenten sind vorzugsweise ausgewählt unter C₁-C₆-Alkyl, C₁-C₆-Alkoxy, Hydroxy, Carboxy, Halogen und Cyano.

Stickstoffhaltige 5- bis 7-gliedrige Heterocycloalkyl- oder Heteroarylreste, die gegebenenfalls weitere unter Sauerstoff und Schwefel ausgewählte Heteroatome enthalten, umfassen beispielsweise Pyrrolyl, Pyrazolyl, Imidazolyl, Triazolyl, Pyrrolidinyl, Pyrazolinyl, Pyrazolidinyl, Imidazolinyl, Imidazolidinyl, Pyridinyl, Pyridazinyl, Pyrimidinyl, Pyrazinyl, Triazinyl, Piperidinyl, Piperazinyl, Oxazolyl, Isooxazolyl, Thiazolyl, Isothiazolyl, Indolyl, Chinolinyl, Isochinolinyl oder Chinaldinyl.

Halogen steht für Fluor, Chlor, Brom oder Iod.

Konkrete Beispiele für die in den folgenden Formeln genannten Reste R^{a} und R^{b} sind im Einzelnen:
Cyclopropyl, Cyclobutyl, Cyclopentyl, 2- und 3-Methylcyclopentyl, 2- und 3-Ethylcyclopentyl, Cyclohexyl, 2-, 3- und 4-Methylcyclohexyl, 2-, 3- und 4-Ethylcyclohexyl, 3- und 4-Propylcyclohexyl, 3- und 4-lsopropylcyclohexyl, 3- und 4-Butylcyclohexyl, 3- und 4-sec.-Butylcyclohexyl, 3- und 4-tert.-Butylcyclohexyl, Cycloheptyl, 2-, 3- und 4-Methyl-cycloheptyl, 2-, 3- und 4-Ethylcycloheptyl, 3- und 4-Propylcycloheptyl, 3- und 4-lso-propylcycloheptyl, 3- und 4-Butylcycloheptyl, 3- und 4-sec.-Butylcycloheptyl, 3- und 4-tert.-Butylcycloheptyl, Cyclooctyl, 2-, 3-, 4- und 5-Methylcyclooctyl, 2-, 3-, 4-und 5-Ethylcyclooctyl und 3-, 4- und 5-Propylcyclooctyl; 3- und 4-Hydroxycyclohexyl, 3- und 4-Nitrocyclohexyl und 3- und 4-Chlorcyclohexyl.
Phenyl, 2-Naphthyl, 2- und 3-Pyrryl, 2-, 3- und 4-Pyridyl, 2-, 4- und 5-Pyrimidyl, 3-, 4-und 5-Pyrazolyl, 2-, 4- und 5-Imidazolyl, 2-, 4- und 5-Thiazolyl, 3-(1,2,4-Triazyl), 2-(1,3,5-Triazyl), 6-Chinaldyl, 3-, 5-, 6- und 8-Chinolinyl, 2-Benzoxazolyl, 2-Benzothiazolyl, 5-Benzothiadiazolyl, 2- und 5-Benzimidazolyl und 1- und 5-lsochinolyl;
1-, 2-, 3-, 4-, 5-, 6- und 7-Indolyl, 1-, 2-, 3-, 4-, 5-, 6- und 7-Isoindolyl, 5-(4-Methyliso-indolyl), 5-(4-Phenylisoindolyl), 1-, 2-, 4-, 6-, 7- und 8-(1,2,3,4-Tetrahydroisochinolinyl), 3-(5-Phenyl)-(1,2,3,4-tetrahydroisochinolinyl), 5-(3-Dodecyl)-(1,2,3,4-tetrahydroiso-chinolinyl), 1-, 2-, 3-, 4-, 5-, 6-, 7- und 8-(1,2,3,4-Tetrahydrochinolinyl) und 2-, 3-, 4-, 5-, 6-, 7- und 8-Chromanyl, 2-, 4- und 7-Chinolinyl, 2-(4-Phenylchinolinyl) und 2-(5-Ethyl-chinolinyl);
2-, 3- und 4-Methylphenyl, 2,4-, 3,5- und 2,6-Dimethylphenyl, 2,4,6-Trimethylphenyl, 2-, 3- und 4-Ethylphenyl, 2,4-, 3,5- und 2,6-Diethylphenyl, 2,4,6-Triethylphenyl, 2-, 3-und 4-Propylphenyl, 2,4-, 3,5- und 2,6-Dipropylphenyl, 2,4,6-Tripropylphenyl, 2-, 3- und 4-Isopropylphenyl, 2,4-, 3,5- und 2,6-Diisopropylphenyl, 2,4,6-Triisopropylphenyl, 2-, 3-und 4-Butylphenyl, 2,4-, 3,5- und 2,6-Dibutylphenyl, 2,4,6-Tributylphenyl, 2-, 3- und 4-Isobutylphenyl, 2,4-, 3,5- und 2,6-Diisobutylphenyl, 2,4,6-Triisobutylphenyl, 2-, 3- und 4-sec.-Butylphenyl, 2,4-, 3,5- und 2,6-Di-sec.-butylphenyl und 2,4,6-Tri-sec.-butyl-phenyl; 2-, 3- und 4-Methoxyphenyl, 2,4-, 3,5- und 2,6-Dimethoxyphenyl, 2,4,6-Tri-methoxyphenyl, 2-, 3- und 4-Ethoxyphenyl, 2,4-, 3,5- und 2,6-Diethoxyphenyl, 2,4,6-Triethoxyphenyl, 2-, 3- und 4-Propoxyphenyl, 2,4-, 3,5- und 2,6-Dipropoxyphenyl, 2-, 3- und 4-lsopropoxyphenyl, 2,4- und 2,6-Diisopropoxyphenyl und 2-, 3- und 4-Butoxy-phenyl; 2-, 3- und 4-Chlorphenyl und 2,4-, 3,5- und 2,6-Dichlorphenyl; 2-, 3-und 4-Hydroxyphenyl und 2,4-, 3,5- und 2,6-Dihydroxyphenyl; 2-, 3- und 4-Cyano-phenyl; 3- und 4-Carboxyphenyl; 3- und 4-Carboxamidophenyl, 3- und 4-N-Methyl-carboxamidophenyl und 3- und 4-N-Ethylcarboxamidophenyl; 3- und 4-Acetylamino-phenyl, 3- und 4-Propionylaminophenyl und 3- und 4-Buturylaminophenyl; 3- und 4-N-Phenylamino-phenyl, 3- und 4-N-(o-Tolyl)aminophenyl, 3- und 4-N-(m-Tolyl)amino-phenyl und 3- und 4-(p-Tolyl)aminophenyl; 3- und 4-(2-Pyridyl)aminophenyl, 3- und 4-(3-Pyridyl)amino-phenyl, 3- und 4-(4-Pyridyl)aminophenyl, 3- und 4-(2-Pyrimidyl)-aminophenyl und 4-(4-Pyrimidyl)aminophenyl;
4-Phenylazophenyl, 4-(1-Naphthylazo)phenyl, 4-(2-Naphthylazo)phenyl, 4-(4-Naphthyl-azo)phenyl,4-(2-Pyriylazo)phenyl, 4-(3-Pyridylazo)phenyl, 4-(4-Pyridylazo)phenyl, 4-(2-Pyrimidylazo)phenyl, 4-(4-Pyrimidylazo)phenyl und 4-(5-Pyrimidylazo)phenyl;
Bevorzugte fluorhaltige Reste R^{a} und R^{b} sind die Folgenden:
   2,2,2-Trifluorethyl, 2,2,3,3,3-Pentafluorpropyl, 2,2-Difluorethyl, 2,2,3,3,4,4,4-Hepta-fluorbutyl, 1H,1H-Pentadecafluoroctyl, 3-Brom-3,3-difluorpropyl, 3,3,3-Trifluorpropyl, 3-(Perfluoroctyl)propyl, 4,4-Difluorbutyl, 4,4,4-Trifluorbutyl, 5,5,6,6,6-Pentafluorhexyl, 2,2-Difluorpropyl, 2-Brom-2,2-difluorethyl, 3,3,3-Trifluor-n-propyl, 1H,1H,2H,2H-Perfluordecyl, 3-(Perfluoroctyl)propyl, Pentafluorphenyl, 2,3,5,6-Tetrafluorphenyl, 4-Cyano-(2,3,5,6)-Tetrafluorphenyl, 4-Carboxy-2,3,5,6-Tetrafluorphenyl, 2,4-Difluorphenyl, 2,4,5-Trifluorphenyl, 2,4,6-Trifluorphenyl, 2,5-Difluorphenyl, 2-Fluor-5-Nitrophenyl, 2-Fluor-5-trifluormethylphenyl, 2-Fluor-5-methylphenyl, 2,6-Difluorphenyl, 4-Carboxamido-2,3,5,6-tetrafluorphenyl, 2-Brom-4,6-difluorphenyl, 4-Brom-2-fluorphenyl, 2,3-Difluorphenyl, 4-Chlor-2-fluorphenyl, 2,3,4-Trifluorphenyl, 2-Fluor-4-iodphenyl, 4-Brom-2,3,5,6-tetrafluorphenyl, 2,3,6-Trifluorphenyl, 2-Brom-3,4,6-trifluorphenyl, 2-Brom-4,5,6-trifluorphenyl, 4-Brom-2,6-difluorphenyl, 2,3,4,5-Tetrafluorphenyl, 2,4-Difluor-6-nitrophenyl, 2-Fluor-4-nitrophenyl, 2-Chlor-6-fluorphenyl, 2-Fluor-4-methylphenyl, 3-Chlor-2,4-difluorphenyl, 2,4-Dibrom-6-fluorphenyl, 3,5-Dichlor-2,4-difluorphenyl, 4-Cyano-2-fluorphenyl, 2-Chlor-4-fluorphenyl, 2-Fluor-3-trifluormethylphenyl, 2-Trifluormethyl-6-fluorphenyl, 2,3,4,6-Tetrafluorphenyl, 3-Chlor-2-fluorphenyl, 5-Chlor-2-fluorphenyl, 2-Brom-4-chlor-6-fluorphenyl, 2,3-Dicyano-4,5,6-trifluorphenyl, 2,4,5-Trifluor-3-carboxyphenyl, 2,3,4-Trifluor-6-carboxyphenyl, 2,3,5-Trifluorphenyl, 4-Trifluormethyl2,3,5,6-tetrafluorphenyl, 2-Fluor-5-carboxyphenyl, 2-Chlor-4,6-difluorphenyl, 6-Brom-3-chlor-2,4-difluorphenyl, 2,3,4-Trifluor-6-nitrophenyl, 2,5-Difluor-4-cyanophenyl, 2,5-Difluor-4-trifluormethylphenyl, 2,3-Difluor-6-nitrophenyl, 4-Trifluormethyl-2,3-difluorphenyl, 2-Brom-4,6-difluorphenyl, 4-Brom-2-fluorphenyl, 2-Nitrotetrafluorphenyl, 2,2',3,3',4',5,5',6,6'-Nonafluorbiphenyl, 2-Nitro-3,5,6-trifluorphenyl, 2-Brom-6-fluorphenyl, 4-Chlor-2-fluor-6-iodphenyl, 2-Fluor-6-carboxyphenyl, 2,4-Difluor-3-trifluorphenyl, 2-Fluor-4-trifluorphenyl, 2-Fluor-4-carboxyphenyl, 4-Brom-2,5-difluorphenyl, 2,5-Dibrom-3,4,6-trifluorphenyl, 2-Fluor-5-methylsulphonylpenyl, 5-Brom-2-fluorphenyl, 2-Fluor-4-hydroxymethylphenyl, 3-Fluor-4-brommethylphenyl, 2-Nitro-4-trifluormethylphenyl, 4-Trifluormethylphenyl, 2-Brom-4-trifluormethylphenyl, 2-Brom-6-Chlor-4-(trifluormethyl)phenyl, 2-Chlor-4-trifluormethylphenyl, 3-Nitro-4-(trifluormethyl)phenyl, 2,6-Dichlor-4-(trifluormethyl)phenyl, 4-Trifluorphenyl, 2,6-Dibrom-4-(trifluormethyl)phenyl, 4-Trifluormethyl-2,3,5,6-tetrafluorphenyl, 3-Fluor-4-trifluormethylphenyl, 2,5-Difluor-4-trifluormethylphenyl, 3,5-Difluor-4-trifluormethylphenyl, 2,3-Difluor-4-trifluormethylphenyl, 2,4-Bis(trifluormethyl)phenyl, 3-Chlor-4-trifluormethylphenyl, 2-Brom-4,5-di(trifluormethyl)phenyl, 5-Chlor-2-nitro-4-(trifluormethyl)phenyl, 2,4,6-Tris(trifluormethyl)phenyl, 3,4-Bis(trifluormethyl)phenyl, 2-Fluor-3-trifluormethylphenyl, 2-lod-4-trifluormethylphenyl, 2-Nitro-4,5-bis(trifluormethyl)phenyl, 2-Methyl-4-(trifluormethyl)phenyl, 3,5-Dichlor-4-(trifluormethyl)phenyl, 2,3,6-Trichlor-4-(trifluormethyl)phenyl.

Perylentetracarbonsäuredianhydride werden als Verbindungen (I.A) bezeichnet.

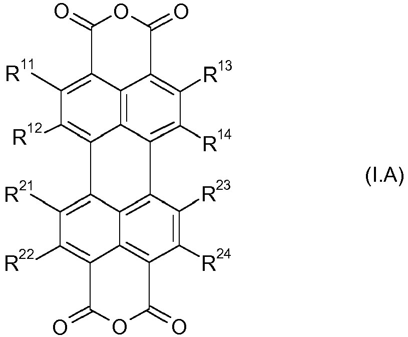

Perylentetracarbonsäurediimide werden als Verbindungen (I.B) bezeichnet, wobei Verbindungen (I.Ba) 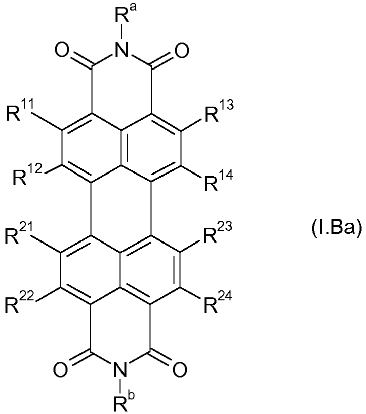 keine zusätzliche verbrückende Gruppe X aufweisen und Verbindungen (I.Bb1) und (I.Bb2) 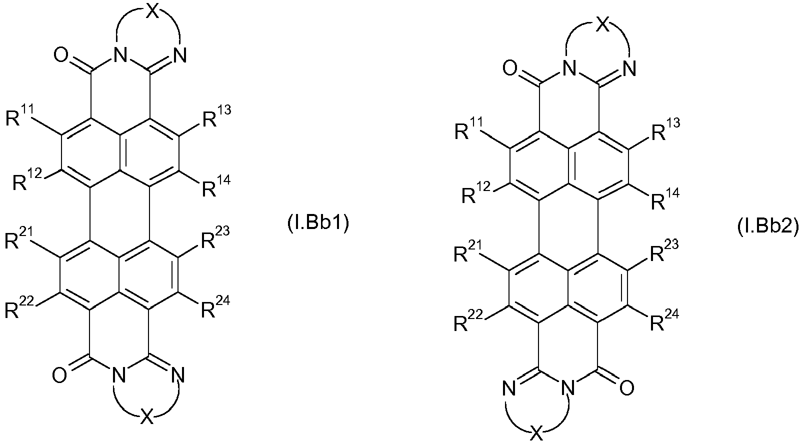 eine solche zusätzliche verbrückende Gruppe X aufweisen.

Eine erste spezielle Ausführungsform betrifft Verbindungen der allgemeinen Formel (I.A), wobei R¹¹, R¹², R¹³, R¹⁴, R²¹, R²², R²³ und R²⁴ die zuvor angegebenen Bedeutungen besitzen.

Eine weitere spezielle Ausführungsform betrifft Verbindungen der allgemeinen Formel (I.Ba), wobei R^{a}, R^{b}, R¹¹, R¹², R¹³, R¹⁴, R²¹, R²², R²³ und R²⁴ eine der zuvor gegebenen Bedeutungen besitzen.

Besonders bevorzugt steht wenigstens einer der Reste R^{a} oder R^{b} in den Verbindungen der Formel (I.Ba) für Wasserstoff. Besonders bevorzugt steht sowohl R^{a} als auch R^{b} für Wasserstoff.

In einer weiteren speziellen Ausführungsform sind die Reste R^{a} und R^{b} gleich.

Eine weitere spezielle Ausführungsform betrifft Verbindungen der allgemeinen Formeln (I.Bb1) und (I.Bb2) wobei R¹¹, R¹², R¹³, R¹⁴, R²¹, R²², R²³ und R²⁴ die zuvor gegebenen Bedeutungen aufweisen und X für eine zweiwertige verbrückende Gruppe mit 2 bis 5 Atomen zwischen den flankierenden Bindungen steht.

Bevorzugt stehen die verbrückenden Gruppen X gemeinsam mit der N-C=N-Gruppe, an die sie gebunden sind für einen 5- bis 8-gliedrigen Heterocyclus steht, der gegebenenfalls ein-, zwei- oder dreifach mit Cycloalkyl, Heterocycloalkyl, Aryl und/oder Hetaryl anelliert ist, wobei die anellierten Gruppen unabhängig voneinander je einen, zwei, drei oder vier Substituenten, ausgewählt unter Alkyl, Alkoxy, Cycloalkyl, Aryl, Halogen, Hydroxy, Mercapto, COOH, Carboxylat, SO₃H, Sulfonat, NE¹E², Alkylen-NE¹E², Nitro und Cyano tragen können, wobei E¹ und E² unabhängig voneinander für Wasserstoff, Alkyl, Cycloalkyl, Heterocycloalkyl, Aryl oder Hetaryl stehen, und/oder X einen, zwei oder drei Substituenten, die ausgewählt sind unter gegebenenfalls substituiertem Alkyl, gegebenenfalls substituiertem Cycloalkyl und gegebenenfalls substituiertem Aryl, aufweisen kann und/oder X durch 1, 2 oder 3 gegebenenfalls substituierte Heteroatome unterbrochen sein kann. Die Heteroatome sind vorzugsweise ausgewählt unter Sauerstoff, Schwefel und Stickstoff.

Vorzugsweise sind die verbrückenden Gruppen X ausgewählt unter Gruppen der Formeln (III.a) bis (III.d) 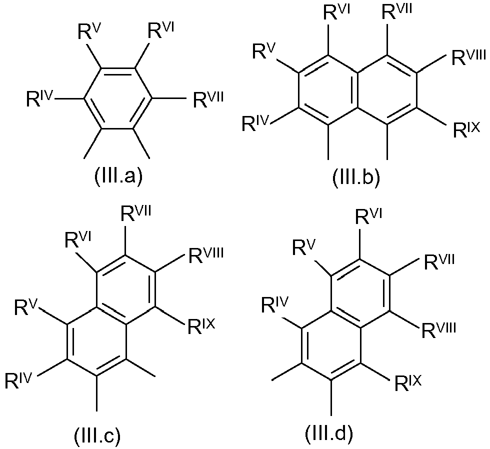 worin
- R^{IV}, R^{V}, R^{VI}, R^{VII}, R^{VIII} und R^{IX}: unabhängig voneinander für Wasserstoff, Alkyl, Alkoxy, Cycloalkyl, Cycloalkoxy, Heterocycloalkyl, Heterocycloalkoxy, Aryl, Aryloxy, Het-aryl, Hetaryloxy, Halogen, Hydroxy, Mercapto, COOH, Carboxylat, SO₃H, Sulfonat, NE¹E², Alkylen-NE¹E², Nitro, Alkoxycarbonyl, Acyl oder Cyano stehen, wobei E¹ und E² unabhängig voneinander für Wasserstoff, Alkyl, Cycloalkyl, Heterocycloalkyl, Aryl oder Hetaryl stehen.

In einer speziellen Ausführung stehen in den Gruppen (III.a) bis (III.d) die Reste R^{IV}, R^{V}, R^{VI}, R^{VII}, R^{VIII} und R^{IX} für Wasserstoff.

Eine weitere spezielle Ausführungsform betrifft Verbindungen der Formeln (I.A), (I.Ba), (I.Bb1) oder (I.Bb2), worin alle Reste R¹¹, R¹², R¹³, R¹⁴, R²¹, R²², R²³ und R²⁴ für Fluor stehen.

Spezielle Beispiele geeigneter Verbindungen der Formeln (I.Ba), (I.Bb1) und (I.Bb2) sind die im Folgenden gezeigten:

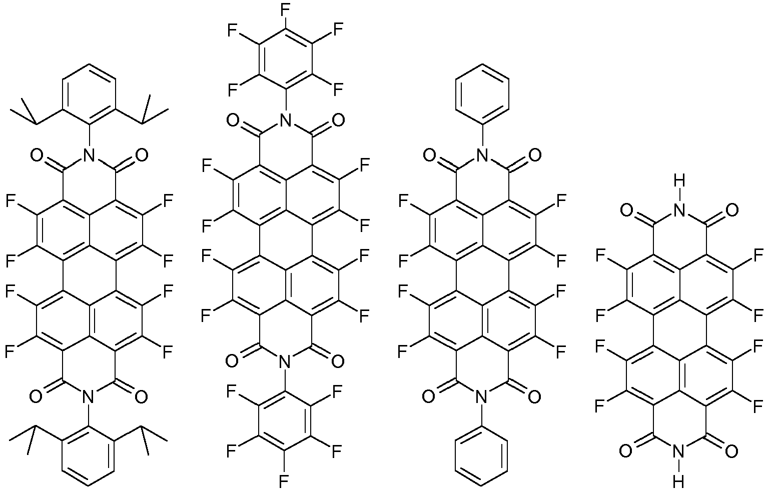

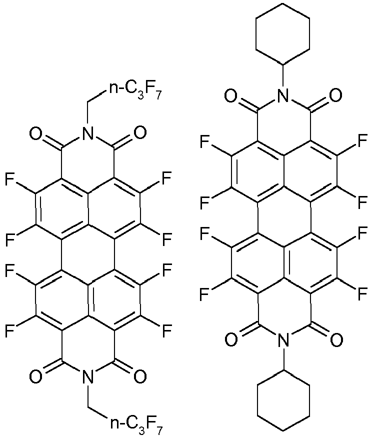

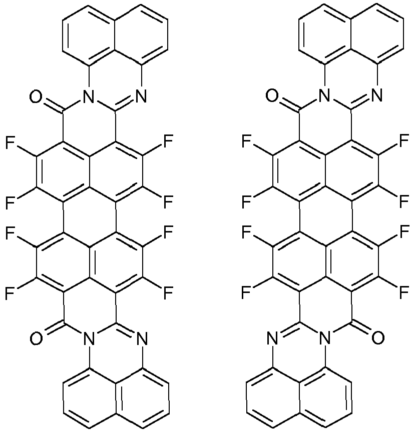

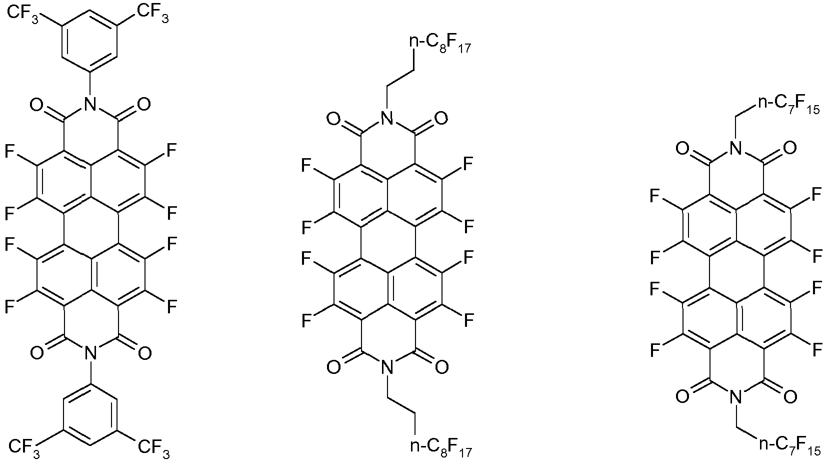

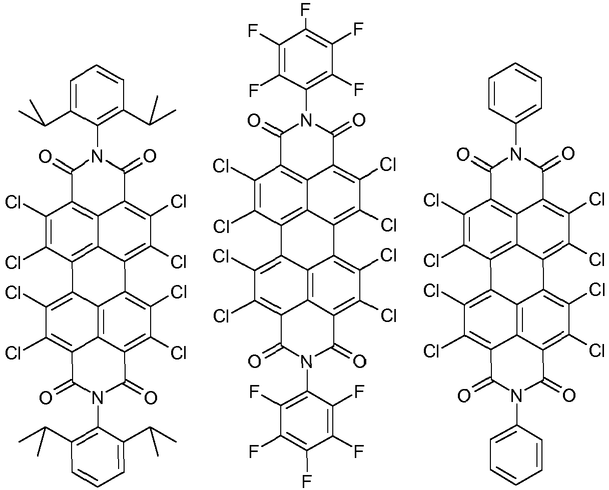

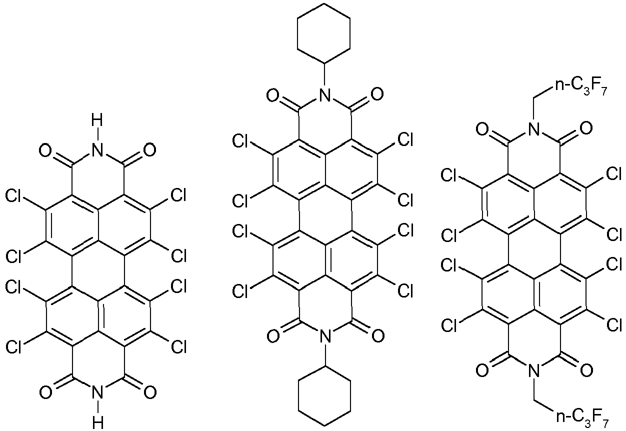

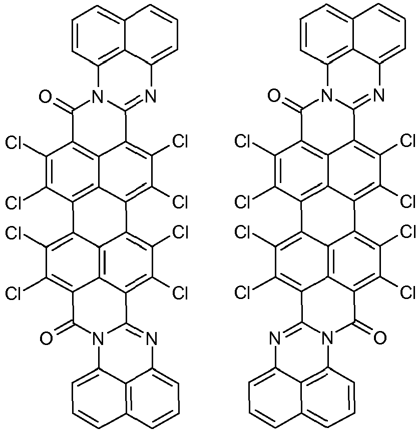

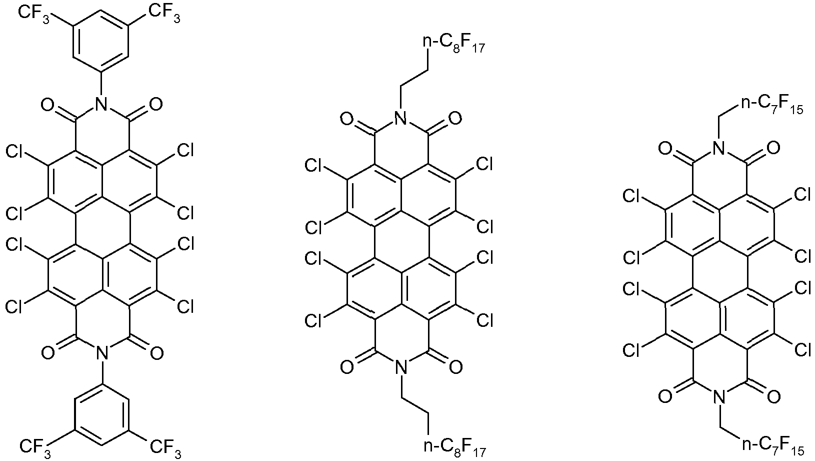

Die Herstellung der erfindungsgemäßen und erfindungsgemäß verwendeten Verbindungen der allgemeinen Formeln (I.A), (I.Ba), (I.Bb1) und (I.Bb2) kann ausgehend von bekannten Verbindungen mit gleichem Perylengrundgerüst, die als Reste R¹¹, R¹², R¹³, R¹⁴, R²¹, R²², R²³ und R²⁴ wenigstens ein Wasserstoffatom aufweisen, erfolgen.

Beschrieben wird ein Verfahren zur Herstellung von Verbindungen der Formel (I), 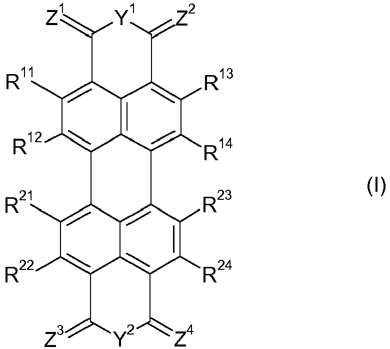 wobei
R¹¹, R¹², R¹³, R¹⁴, R²¹, R²², R²³ und R²⁴, eine der zuvor gegebenen Bedeutungen aufweisen;
- Y¹: für O oder NR^{a} steht, wobei R^{a} für Wasserstoff steht oder einen der zuvor genannten Bedeutungen aufweist;
- Y²: für O oder NR^{b} steht, wobei R^{b} für Wasserstoff steht oder einen der zuvor genannten Bedeutungen aufweist;
Z¹, Z², Z³ und Z⁴ für O stehen;
wobei für den Fall, dass Y¹ für NR^{a} steht, auch einer der Reste Z¹ und Z² für NR^{c} stehen kann, wobei die Reste R^{a} und R^{c} gemeinsam für eine verbrückende Gruppe X mit 2 bis 5 Atomen zwischen den flankierenden Bindungen stehen, und
wobei für den Fall, dass Y² für NR^{b} steht, auch einer der Reste Z³ und Z⁴ für NR^{d} stehen kann, wobei die Reste R^{b} und R^{d} gemeinsam für eine verbrückende Gruppe X mit 2 bis 5 Atomen zwischen den flankierenden Bindungen stehen,
bei dem man
a) eine Verbindung der Formel (II), 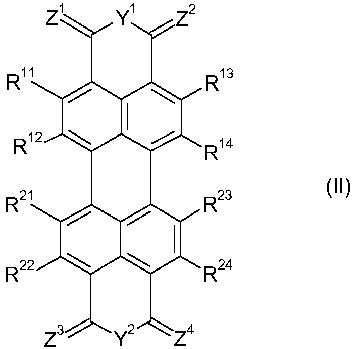 worin
   R¹¹, R¹², R¹³, R¹⁴, R²¹, R²², R²³, R²⁴ ausgewählt sind unter Wasserstoff und Cl, und
   Y¹, Y², Z¹, Z², Z³ und Z⁴ eine der zuvor gegebenen Bedeutungen aufweisen,
   wobei wenigstens einer der Reste R¹¹, R¹², R¹³, R¹⁴, R²¹, R²², R²³, R²⁴ für Wasserstoff steht, 0 bis 7 der Reste R¹¹, R¹², R¹³, R¹⁴, R²¹, R²², R²³, R²⁴ für Cl stehen,
   einer Chlorierung unter Erhalt einer Verbindung der Formel (I), worin die Reste R¹¹, R¹², R¹³, R¹⁴, R²¹, R²², R²³ und R²⁴ für Chlor stehen,
   unterwirft und
b) gegebenenfalls die in Schritt a) erhaltene Verbindung der Formel (I) einem vollständigen Austausch von Chlor gegen Fluor unterwirft.

### Schritt a)

Methoden zur Chlorierung von Aromaten sind dem Fachmann grundsätzlich bekannt. Die Verbindungen der Formel (I), worin die Reste R¹¹, R¹², R¹³, R¹⁴, R²¹, R²², R²³ und R²⁴ für Chlor stehen, können aus den entsprechenden Verbindungen der Formel (II), worin wenigstens einer der Reste R¹¹, R¹², R¹³, R¹⁴, R²¹, R²², R²³ und R²⁴ für Wasserstoff steht, durch Umsetzung mit einem Chlorierungsmittel, wie Thionylchlorid, Chlorsulfonsäure, Sulfurylchlorid oder Chlor, in einem inerten Lösungsmittel hergestellt werden.

Eine besonders bevorzugte Ausführungsform der vorliegenden Erfindung betrifft die Verwendung von Chlorsulfonsäure als Lösungsmittel (und nicht als Chlorierungsmittel) in Schritt a) des Verfahrens. In dieser Ausgestaltung des Verfahrens wird dann vorzugsweise Chlor als Chlorierungsmittel eingesetzt.

Die Umsetzung der Verbindungen der Formel (II) mit einem Chlorierungsmittel findet bevorzugt in Gegenwart eines Katalysators statt. Als Katalysatoren kommen beispielsweise Iod oder lodbenzol, sowie deren Gemische in Frage.

In einer speziellen Ausführungsform des Verfahrens erfolgt die Chlorierung der Verbindung der Formel (II) durch Umsetzung mit Chlor in Chlorsulfonsäure und in Gegenwart katalytischer Mengen Iod.

Die Reaktionstemperatur für die Umsetzung mit einem Chlorierungsmittel liegt üblicherweise in einem Bereich von 35 bis 110 °C, vorzugsweise von 40 bis 95 °C.

Die Umsetzung der Verbindungen der Formel (II) mit einem Chlorierungsmittel kann unter Normaldruck oder unter erhöhtem Druck bewirkt werden.

Die Isolierung der Verbindungen der Formel (I) aus dem Reaktionsgemisch erfolgt üblicherweise durch Fällung. Die Fällung wird beispielsweise durch Zugabe einer Flüssigkeit, die die Verbindungen nicht oder nur in geringem Masse löst jedoch mit dem inerten Lösungsmitteln mischbar ist, bewirkt. Die Fällungsprodukte können dann durch Filtration isoliert werden und weisen üblicherweise eine ausreichend hohe Reinheit auf.

Für einen Einsatz der Produkte als Halbleiter kann es von Vorteil sein, die Produkte einer weiteren Aufreinigung zu unterziehen. Dazu zählen beispielsweise säulenchromatographische Verfahren, wobei die Produkte z. B. in einem halogenierten Kohlenwasserstoff, wie Methylenchlorid oder einem Toluol/ oder Petrolether/Essigester-Gemisch gelöst, einer Auftrennung bzw. Filtration an Kieselgel unterzogen werden. Des Weiteren ist eine Reinigung durch Sublimation oder Kristallisation möglich.

Falls erforderlich, werden die Aufreinigungsschritte ein- oder mehrfach wiederholt und/oder es werden verschiedene Aufreinigungsschritte kombiniert, um sehr reine Verbindungen (I) zu erhalten.

In einer bevorzugten Ausführungsform des Verfahrens wird die Chlorierung der Verbindung der Formel (II) durch Umsetzung mit Chlor in Chlorsulfonsäure (als Lösungsmittel) und in Gegenwart katalytischer Mengen Iod bewirkt. In dieser Ausführungsform erfolgt die Isolierung der Verbindungen der Formel (I) bevorzugt durch Zugabe von Wasser und Isolierung des dabei ausfallenden Feststoffs.

Üblicherweise wird man bei der Herstellung der Verbindungen der Formel (I) von den entsprechenden Verbindungen der Formel (II) ausgehen, worin alle Reste R¹¹, R¹², R¹³, R¹⁴, R²¹, R²², R²³ und R²⁴ für Wasserstoff stehen. In einer speziellen Ausführungsform stehen R¹¹ bis R¹⁴ und R²¹ bis R²⁴ jeweils für Wasserstoff. Es kann jedoch auch vorteilhaft sein, von teilchlorierten Verbindungen der Formel (II) auszugehen, insbesondere wenn diese aufgrund der erhöhten Reaktivität ihrer Vorgängerverbindungen besser zugänglich sind.

Weisen die Reste R^{a}, R^{b} aromatische Gruppen auf, können auch diese unter den zuvor beschriebenen Chlorierungsbedingungen chloriert werden. Aus diesem Grund kann es zweckmäßig sein zunächst das Perylengrundgerüst zu chlorieren und die Reste R^{a}, R^{b} im Anschluss, beispielsweise durch eine Imidierungsreaktion einzuführen.

### Schritt b)

Die Herstellung der Verbindungen der allgemeinen Formel (I), worin die Reste R¹¹, R¹², R¹³, R¹⁴, R²¹, R²², R²³ und R²⁴ für Fluor stehen, kann ausgehend von den in Schritt a) bereitgestellten Verbindungen der Formel (I) mit gleichem Rylengrundgerüst, durch vollständigen Austausch von Chlor gegen Fluor erfolgen. Bedingungen für einen solchen Halogenaustausch sind dem Fachmann hinreichend bekannt.

In einer Ausführungsform des Verfahrens wird man zur Herstellung von Verbindungen der Formel (I), worin R¹¹, R¹², R¹³, R¹⁴, R²¹, R²², R²³ und R²⁴ für Fluor stehen, die in Schritt a) erhaltene Verbindung der Formel (I) mit einem Alkalifluorid unter im Wesentlichen wasserfreien Bedingungen umsetzten.

Unter "im Wesentlichen wasserfreien Bedingungen" wird im Rahmen der Erfindung ein Gesamtwassergehalt, bezogen auf alle an der Reaktion beteiligten Komponenten (Edukte, Lösungsmittel, Komplexbildner, etc.), von höchstens 2 Gew.-%, bevorzugt von höchstens 1 Gew.-%, insbesondere von höchstens 0,1 Gew.-%, verstanden. Zur Erzielung der wasserfreien Reaktionsbedingungen können die an der Umsetzung beteiligten Komponenten einer Trocknung nach üblichen, dem Fachmann bekannten Verfahren unterzogen werden.

Geeignete Verfahrensbedingungen zur aromatischen nucleophilen Substitution von Chloratomen durch Fluoratome (Halogenaustausch) sind prinzipiell bekannt. Geeignete Bedingungen zum Halogenaustausch sind z. B. in J. March, Advanced Organic Chemistry, 4. Auflage, Verlag John Wiley & Sons (1992), S. 659 sowie in der DE 32 35 526 beschrieben.

In einer ersten Ausführungsform handelt es sich bei der Umsetzung um einen Austausch der Chloratome durch Fluoratome. Zur Einfügung der Fluorgruppen wird vorzugsweise ein Alkalifluorid, insbesondere KF, NaF oder CsF, eingesetzt. Es werden vorzugsweise 1 bis 30 Äquivalente Alkalifluorid je Äquivalent Rylenverbindung eingesetzt.

Bevorzugte Lösungsmittel für den Halogenaustausch sind aprotisch polare Lösungsmittel, wie Dimethylformamid, N-Methylpyrrolidon, (CH₃)₂SO, Dimethylsulfon, N,N'-Dimethylimidazolidinon oder Sulfolan. Besonders bevorzugt wird Sulfolan als Lösungsmittel eingesetzt. Vorzugsweise werden die Lösungsmittel vor ihrem Einsatz einer Trocknung zur Entfernung von Wasser nach üblichen, dem Fachmann bekannten Methoden unterzogen. Ebenfalls geeignet sind aprotische Lösungsmittel wie aromatische Kohlenwasserstoffe z.B. Xylole, beispielsweise. o-Xylol.

Üblicherweise wird man die in Schritt a) erhaltene Verbindung der Formel (I) dem Halogenaustausch in Form einer Lösung, die eine Konzentration von 0,002 bis 0,2 mol/l, bevorzugt 0,01 bis 0,1 mol/l, aufweist in einem der zuvor genannten Lösungsmittel, unterwerfen.

Zum Halogenaustausch kann zusätzlich ein Komplexbildner, wie z. B. ein Kronenether eingesetzt werden. Dazu zählen z. B. [12]Krone-4, [15]Krone-5, [18]Krone-6, [21]Krone-7, [24]Krone-8, etc. Die Auswahl des Komplexbildners erfolgt nach seiner Befähigung zur Komplexierung der Alkalimetalle der zum Halogenaustausch eingesetzten Alkalihalogenide. Wird zur Einfügung der Fluorgruppen KF eingesetzt, so wird als Komplexbildner bevorzugt [18]Krone-6 eingesetzt. Es werden vorzugsweise 0,1 bis 10 Äquivalente Kronenether je Äquivalent Rylenverbindung eingesetzt.

Weitere geeignete Phasentransferkatalysatoren sind beispielsweise ausgewählt unter 2-Azaalleniumverbindungen, Carbophosphazeniumverbindungen, Aminophosphoniumverbindungen und Diphosphazeniumverbindungen. A. Pleschke, A. Marhold, M. Schneider, A. Kolomeitsev und G. V. Röschenthaler geben im Journal of Fluorine Chemistry 125, 2004, 1031-1038 eine Übersicht über weitere geeignete Phasentransferkatalysatoren. Auf die Offenbarung dieses Dokuments wird Bezug genommen. In einer bevorzugten Ausführung werden 2-Azaalleniumverbindungen, wie (N,N-Dimethylimidazolidino)-tetramethylguanidiniumchlorid eingesetzt. Die Einsatzmenge dieser Phasentransferkatalysatoren beträgt vorzugsweise 0,1 bis 20 Gew.-%, bevorzugt 1 bis 10 Gew.-%, bezogen auf das Gewicht der eingesetzten Rylenverbindung.

Die Reaktionstemperaturen für den Halogenaustausch liegen vorzugsweise bei 100 bis 200 °C. Die Reaktionszeit liegt vorzugsweise bei 0,5 bis 48 Stunden.

Demzufolge betrifft ein weiterer Gegenstand der vorliegenden Erfindung Verfahren zur Herstellung von Verbindungen der Formel (I.Ba), 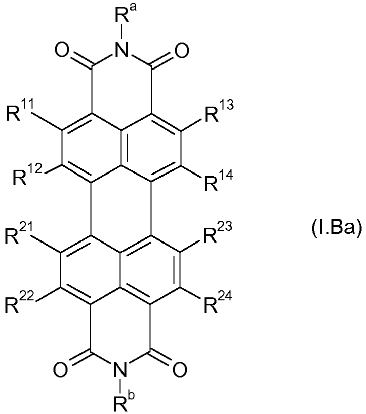 worin R¹¹, R¹², R¹³, R¹⁴, R²¹, R²², R²³ und R²⁴ eine der zuvor gegebenen Bedeutungen aufweisen, bei dem man
1) ein Rylendianhydrid der Formel (II.A) 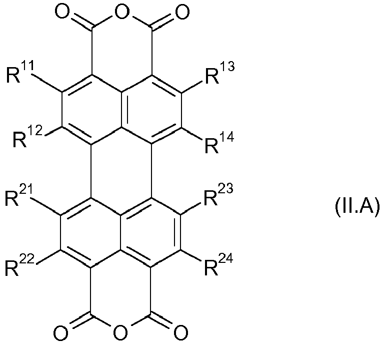 worin
   R¹¹, R¹², R¹³, R¹⁴, R²¹, R²², R²³, R²⁴ ausgewählt sind unter Wasserstoff und Cl,
   wobei wenigstens einer der Reste R¹¹, R¹², R¹³, R¹⁴, R²¹, R²², R²³, R²⁴ für Wasserstoff steht, und 0 bis 7 der Reste R¹¹, R¹², R¹³, R¹⁴, R²¹, R²², R²³, R²⁴ für Cl stehen,
   Schritt a) und gegebenenfalls Schritt b) des Verfahrens zur Herstellung von Verbindungen (I) unterwirft, und
2) die in Schritt 1) erhaltene Verbindung einer Umsetzung mit einem Amin der Formel R^{a}-NH₂ und gegebenenfalls einem davon verschiedenen Amin der Formel R^{b}-NH₂ unterwirft.

Alternativ können die Verbindungen der Formel (I.Ba) durch ein Verfahren, wobei man
1') ein Rylendianhydrid der Formel (II.A), zunächst einer Umsetzung mit einem Amin der Formel R^{a}-NH₂ und gegebenenfalls einem davon verschiedenen Amin der Formel R^{b}-NH₂ unterwirft, und
2') die in Schritt 1') erhaltene Verbindung Schritt a) und gegebenenfalls Schritt b) des Verfahrens zur Herstellung von Verbindungen (I) unterwirft,
hergestellt werden.

Ein weiterer Gegenstand der vorliegenden Erfindung betrifft ein Verfahren zur Herstellung von Verbindungen der Formeln (I.Bb1) und/oder (I.Bb2), 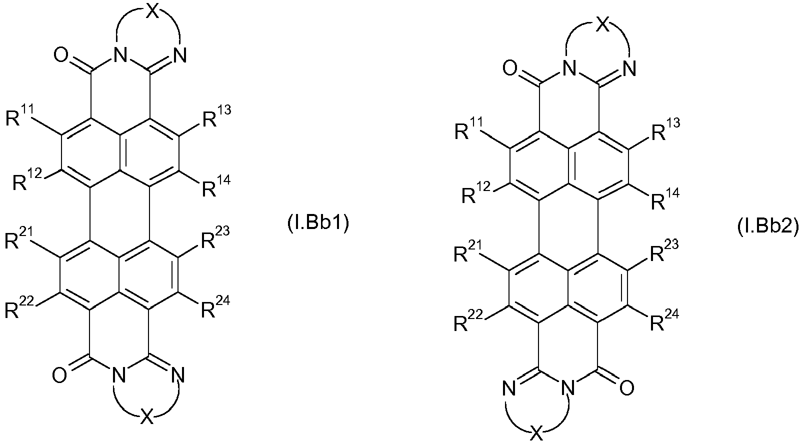 wobei R¹¹, R¹², R¹³, R¹⁴, R²¹, R²², R²³ und R²⁴ und X eine der zuvor gegebenen Bedeutungen aufweisen, bei dem man
1") ein Rylendianhydrid der Formel (II.A), 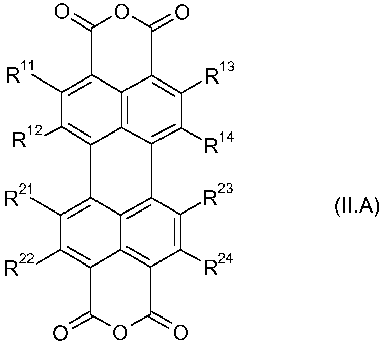 worin
   R¹¹, R¹², R¹³, R¹⁴, R²¹, R²², R²³, R²⁴ ausgewählt sind unter Wasserstoff, und Cl, und
   wobei wenigstens einer der Reste R¹¹, R¹², R¹³, R¹⁴, R²¹, R²², R²³, R²⁴ für Wasserstoff steht und 0 bis 7 der Reste R¹¹, R¹², R¹³, R¹⁴, R²¹, R²², R²³, R²⁴ für Cl stehen,
   Schritt a) und gegebenenfalls Schritt b) des Verfahrens zur Herstellung von Verbindungen (I) unterwirft, und
2") die in Schritt 1") erhaltene Verbindung einer Umsetzung mit einem Amin der Formel H₂N-X-NH₂ unterwirft.

Alternativ können die Verbindungen der Formeln (I.Bb1) und/oder (I.Bb2) durch ein Verfahren, bei dem man
1"') ein Rylendianhydrid der Formel (II.A), einer Umsetzung mit einem Amin der Formel H₂N-X-NH₂ unterwirft, und
2"') die in Schritt 1"') erhaltene Verbindung Schritt a) und gegebenenfalls Schritt b) des Verfahrens zur Herstellung von Verbindungen (I) unterwirft,
hergestellt werden.

Die Imidierung der Carbonsäureanhydridgruppen in den Reaktionsschritten 2), 1'), 2") und 1"') ist prinzipiell bekannt und z. B. in der DE 10 2004 007 382 A1 beschrieben. Vorzugsweise erfolgt die Umsetzung des Dianhydrids mit dem primären Amin in Gegenwart eines aromatischen Lösungsmittels, wie Toluol, Xylol, Mesitylen, Phenol oder eines polaren aprotischen Lösungsmittels. Geeignete polare aprotische Lösungsmittel sind Stickstoffheterocyclen, wie Pyridin, Pyrimidin, Chinolin, Isochinolin, Chinaldin, N-Methylpiperidin, N-Methylpiperidon und N-Methylpyrrolidon. Zur Umsetzung mit einem aromatischen Diamin der Formel H₂N-X-NH₂ wird vorzugsweise ein Stickstoffheterocyclus oder Phenol als Lösungsmittel eingesetzt. Geeignete Katalysatoren sind die im Folgenden genannten. Bei Verwendung von Phenol als Lösungsmittel wird als Katalysator vorzugsweise Piperazin eingesetzt.

Die Reaktion kann in Gegenwart eines Imidierungskatalysators vorgenommen werden. Als Imidierungskatalysatoren eignen sich organische und anorganische Säuren, z. B. Ameisensäure, Essigsäure, Propionsäure und Phosphorsäure. Geeignete Imidierungskatalysatoren sind weiterhin organische und anorganische Salze von Übergangsmetallen, wie Zink, Eisen, Kupfer und Magnesium. Dazu zählen z. B. Zinkacetat, Zinkpropionat, Zinkoxid, Eisen(II)acetat, Eisen(III)chlorid, Eisen(II)sulfat, Kupfer(II)acetat, Kupfer(II)oxid und Magnesiumacetat. Der Einsatz eines Imidierungskatalysators erfolgt vorzugsweise bei der Umsetzung aromatischer Amine und ist im Allgemeinen auch zur Umsetzung cycloaliphatischer Amine vorteilhaft. Bei der Umsetzung aliphatischer Amine, insbesondere kurzkettiger aliphatischer Amine, kann in der Regel auf den Einsatz eines Imidierungskatalysators verzichtet werden. Die Einsatzmenge des Imidierungskatalysators beträgt vorzugsweise 5 bis 80 Gew.-%, besonders bevorzugt 10 bis 75 Gew.-%, bezogen auf das Gesamtgewicht der zu amidierenden Verbindung.

Vorzugsweise liegt das Molmengenverhältnis von Amin zu Dianhydrid bei etwa 2 : 1 bis 10 : 1, besonders bevorzugt 2 : 1 bis 4 : 1, z. B. 2,2 : 1 bis 3 : 1.

Die zuvor als Imidierungskatalysatoren genannten organischen Säuren eignen sich auch als Lösungsmittel.

Die Reaktionstemperatur beträgt in den Schritten 2), 1'), 2") und 1"') im Allgemeinen Umgebungstemperatur bis 200 °C, vorzugsweise 40 bis 160 °C. Die Umsetzung aliphatischer und cycloaliphatischer Amine erfolgt vorzugsweise in einem Temperaturbereich von etwa 60 °C bis 100 °C. Die Umsetzung aromatischer Amine erfolgt vorzugsweise in einem Temperaturbereich von etwa 120 bis 160 °C.

Vorzugsweise erfolgt die Umsetzung in den Reaktionsschritte 2), 1'), 2") und 1"') unter einer Schutzgasatmosphäre, wie z. B. Stickstoff.

Die Reaktionsschritte 2), 1'), 2") und 1"') können bei Normaldruck oder gewünschtenfalls unter erhöhtem Druck erfolgen. Ein geeigneter Druckbereich liegt im Bereich von etwa 0,8 bis 10 bar. Vorzugsweise beim Einsatz flüchtiger Amine (Siedepunkt etwa ≤ 180 °C) bietet sich der Einsatz unter erhöhtem Druck an.

Das bei der Reaktion in den Schritten 2), 1'), 2") und 1"') entstehende Wasser kann durch Destillation nach dem Fachmann bekannten Verfahren abgetrennt werden.

In der Regel können die im Reaktionsschritt 2), 1'), 2") und 1"') erhaltenen Diimide ohne weitere Reinigung verwendet werden. Für einen Einsatz der Produkte als Halbleiter kann es jedoch von Vorteil sein, die Produkte einer weiteren Aufreinigung zu unterziehen. Dazu zählen beispielsweise säulenchromatographische Verfahren, wobei die Produkte vorzugsweise in einem halogenierten Kohlenwasserstoff, wie Methylenchlorid, oder in einem aromatischen Kohlenwasserstoff gelöst werden und einer Auftrennung bzw. Filtration an Kieselgel unterzogen werden.

Die erfindungsgemäßen und nach dem erfindungsgemäßen Verfahren erhältlichen Verbindungen eignen sich besonders vorteilhaft als organische Halbleiter. Sie fungieren dabei in der Regel als n-Halbleiter. Werden die erfindungsgemäß eingesetzten Verbindungen der Formeln (I.A), (I.Ba), (I.Bb1) und (I.Bb2) mit anderen Halbleitern kombiniert und ergibt sich aus der Lage der Energieniveaus, dass die anderen Halbleiter als n-Halbleiter fungieren, so können die Verbindungen (I.A), (I.Ba), (I.Bb1) und (I.Bb2) auch ausnahmsweise als p-Halbleiter fungieren.

Die Verbindungen der Formel (I.A), (I.Ba), (I.Bb1) und (I.Bb2) zeichnen sich durch ihre Luftstabilität aus. Weiterhin verfügen sie über eine hohe Ladungstransportmobilität, die sie deutlich gegenüber bekannten organischen Halbleitermaterialen heraushebt. Sie haben zudem ein hohes on/off-Verhältnis.

Die Verbindungen der Formel (I.A), (I.Ba), (I.Bb1) und (I.Bb2) eignen sich in besonders vorteilhafter Weise für organische Feldeffekttransistoren. Sie können beispielsweise zur Herstellung von integrierten Schaltkreisen (ICs) eingesetzt werden, für die bislang übliche n-Kanal MOSFET (metal oxide semiconductor field-effect transistor) zum Einsatz kommen. Dabei handelt es sich dann um CMOS-analoge Halbleiterbausteine, z. B. für Mikroprozessoren, Mikrokontroller, statische RAM, und andere digitale logic circuits. Zur Herstellung von Halbleitermaterialien können die Verbindungen der Formel (I.A), (I.Ba), (I.Bb1) und (I.Bb2) nach einem der folgenden Verfahren weiterverarbeitet werden: Drucken (Offset, Flexo, Gravur, Screen, Inkjet, Elektrofotografie), Verdampfen, Lasertransfer, Fotolithografie, Dropcasting. Sie eignen sich insbesondere für einen Einsatz in Displays (speziell großflächigen und/oder flexiblen Displays) und RFID-Tags.

Die Verbindungen der Formel (I.A), (I.Ba), (I.Bb1) und (I.Bb2) eignen sich besonders vorteilhaft als Elektronenleiter in organischen Feldeffekttransistoren, organischen Solarzellen und in organischen Leuchtdioden. Sie eignen sich weiterhin besonders vorteilhaft als Excitonentransportmaterial in excitonischen Solarzellen.

Die Verbindungen der Formel (I.A), (I.Ba), (I.Bb1) und (I.Bb2) eignen sich weiterhin besonders vorteilhaft als Fluoreszenzfarbstoff in einem auf Fluoreszenzkonversion beruhenden Display. Derartige Displays umfassen im Algemeinen ein transparentes Substrat, einen auf dem Substrat befindlichen Fluoreszenzfarbstoff und eine Strahlungsquelle. Übliche Strahlungsquellen senden blaues (color by blue) oder UV-Licht (color by uv) aus. Die Farbstoffe absorbieren entweder das blaue oder das UV-Licht und werden als Grünemitter eingesetzt. In diesen Displays wird z. B. das rote Licht erzeugt, indem der Rotemitter durch einen blaues oder UV-Licht absorbierenden Grünemitter angeregt wird. Geeignete color-by-blue-Displays sind z. B. in der WO 98/28946 beschrieben. Geeignete color-by-uv-Displays werden z. B. von W.A. Crossland, I.D. Sprigle und A.B. Davey in Photoluminescent LCDs (PL-LCD) using phosphors Cambridge University and Screen Technology Ltd., Cambridge, UK beschrieben. Die Verbindungen der Formel (I.A), (I.Ba), (I.Bb1) oder (I.Bb2) eignen sich weiterhin besonders in Displays, welche basierend auf einem elektrophoretischen Effekt über geladene Pigmentfarbstoffe Farben an- und ausschalten. Derartige elektrophoretische Displays sind z. B. in US 2004/0130776 beschrieben.

Gegenstand der Erfindung sind weiterhin organische Feldeffekttransistoren, umfassend ein Substrat mit wenigstens einer Gate-Struktur, einer Source-Elektrode und einer Drain-Elektrode und wenigstens einer Verbindung der Formel (I.A), (I.Ba), (I.Bb1) oder (I.Bb2), wie zuvor definiert, als Halbleiter, speziell als n-Halbleiter.

Gegenstand der Erfindung sind weiterhin Substrate mit einer Vielzahl von organischen Feldeffekttransistoren, wobei zumindest ein Teil der Feldeffektransistoren wenigstens einer Verbindung der Formel (I.A), (I.Ba), (I.Bb1) oder (I.Bb2), wie zuvor definiert, als n-Halbleiter enthält.

Gegenstand der Erfindung sind auch Halbleiterbausteine, die wenigstes ein solches Substrat umfassen.

Eine spezielle Ausführungsform ist ein Substrat mit einem Muster (Topographie) von organischen Feldeffekttransistoren, wobei jeder Transistor
- einen auf dem Substrat befindlichen organischen Halbleiter;
- eine Gate-Struktur zur Steuerung der Leitfähigkeit des leitenden Kanals; und
- leitfähige Source- und Drain-Elektroden an den beiden Enden des Kanals
enthält, wobei der organische Halbleiter aus wenigstens einer Verbindung der Formel (I.A), (I.Ba), (I.Bb1) oder (I.Bb2) besteht oder eine Verbindung der Formel (I.A), (I.Ba), (I.Bb1) oder (I.Bb2) umfasst. Des Weiteren umfasst der organische Feldeffekttransistor in der Regel ein Dielektrikum.

Eine weitere spezielle Ausführungsform ist ein Substrat mit einem Muster von organischen Feldeffekttransistoren, wobei jeder Transistor einen integrierten Schaltkreis bildet oder Teil eines integrierten Schaltkreises ist und wobei zumindest ein Teil der Transistoren wenigstens eine Verbindung der Formel (I.A), (I.Ba), (I.Bb1) oder (I.Bb2) umfasst.

Als Substrate eignen sich prinzipiell die dafür bekannten Materialien. Geeignete Substrate umfassen z. B. Metalle (vorzugsweise Metalle der Gruppen 8, 9, 10 oder 11 des Periodensystems, wie Au, Ag, Cu), oxidische Materialien (wie Glas, Keramiken, SiO₂, insbesondere Quarz), Halbleiter (z. B. dotiertes Si, dotiertes Ge), Metalllegierungen (z. B. auf Basis von Au, Ag, Cu, etc.), Halbleiterlegierungen, Polymere (z. B. Polyvinylchlorid, Polyolefine, wie Polyethylen und Polypropylen, Polyester, Fluoropolymere, Polyamide, Polyimide, Polyurethane, Polyalkyl(meth)acrylate, Polystyrol und Mischungen und Komposite davon), anorganische Feststoffe (z. B. Ammoniumchlorid), Papier und Kombinationen davon. Die Substrate können flexibel oder unflexibel, mit gekrümmter oder planarer Geometrie sein, abhängig von der gewünschten Anwendung.

Ein typisches Substrat für Halbleiterbausteine umfasst eine Matrix (z. B. eine Quartz- oder Polymermatrix) und, optional, eine dielektrische Deckschicht.

Geeignete Dielektrika sind SiO₂, Polystyrol, Poly-α-methylstyrol, Polyolefine (wie Polypropylen, Polyethylen, Polyisobuten) Polyvinylcarbazol, fluorierte Polymere (z. B. Cytop), Cyanopulluane (z. B. CYMM), Polyvinylphenol, Poly-p-xylol, Polyvinylchlorid oder thermisch oder durch Luftfeuchtigkeit vernetzbare Polymere. Spezielle Dielektrika sind "self assembled nanodielectrics", d. h. Polymere, welche aus SiCI-Funktionalitäten enthaltenden Monomeren wie z. B. Cl₃SiOSiCl₃, Cl₃Si-(CH₂)₆-SiCl₃, Cl₃Si-(CH₂)₁₂-SiCl₃ erhalten und/oder welche durch Luftfeuchtigkeit oder durch Zugabe von Wasser in Verdünnung mit Lösungsmitteln vernetzt werden (siehe z. B. Faccietti Adv. Mat. 2005, 17, 1705-1725). An Stelle von Wasser können auch Hydroxylgruppen-haltige Polymere wie Polyvinylphenol oder Polyvinylalkohol oder Copolymere aus Vinylphenol und Styrol als Vernetzungskomponenten dienen. Es kann auch wenigstens ein weiteres Polymer während des Vernetzungsvorgangs zugegen sein, wie z. B. Polystyrol, welches dann mitvernetzt wird (siehe Facietti, US-Patentanmeldung 2006/0202195).

Das Substrat kann zusätzlich Elektroden aufweisen, wie Gate-, Drain- und Source-Elektroden von OFETs, die normalerweise auf dem Substrat lokalisiert sind (z. B. abgeschieden auf oder eingebettet in eine nichtleitende Schicht auf dem Dielektrikum). Das Substrat kann zusätzlich leitfähige Gate-Elektroden der OFETs enthalten, die üblicherweise unterhalb der dielektrischen Deckschicht (d. h. dem Gate-Dielektrikum) angeordnet sind.

Nach einer speziellen Ausführung befindet sich eine Isolatorschicht (gate insulating layer) auf wenigstes einem Teil der Substratoberfläche. Die Isolatorschicht umfasst wenigstens einen Isolator, der vorzugsweise ausgewählt ist unter anorganischen Isolatoren, wie SiO₂, Si₃N₄, etc., ferroelektrischen Isolatoren, wie Al₂O₃, Ta₂O₅, La₂O₅, TiO₂, Y₂O₃, etc., organischen Isolatoren, wie Polyimiden, Benzocyclobuten (BCB), Polyvinylalkoholen, Polyacrylaten, etc. und Kombinationen davon.

Geeignete Materialien für Source- und Drain-Elektroden sind prinzipiell elektrisch leitfähige Materialien. Dazu zählen Metalle, vorzugsweise Metalle der Gruppen 6, 8, 9, 10 oder 11 des Periodensystems, wie Pd, Au, Ag, Cu, Al, Ni, Cr, etc. Geeignet sind weiterhin leitfähige Polymere, wie PEDOT (=Poly(3,4-ethylendioxythiophen):PSS (= Poly(styrolsulfonat), Polyanilin, oberflächenmodifiziertes Gold, etc. Bevorzugte elektrisch leitfähige Materialien haben einen spezifischen Widerstand von weniger als 10 ⁻³, vorzugsweise weniger als 10 ⁻⁴, insbesondere weniger als 10 ⁻⁶ oder 10 ⁻⁷ Ohm x Meter.

Nach einer speziellen Ausführung befinden sich Drain- und Source-Elektroden zumindest teilweise auf dem organischen Halbleitermaterial. Selbstverständlich kann das Substrat weitere Komponenten umfassen, wie sie üblicherweise in Halbleitermaterialien oder ICs eingesetzt werden, wie Isolatoren, Widerstände, Kondensatoren, Leiterbahnen, etc.

Die Elektroden können nach üblichen Verfahren, wie Verdampfen, lithographische Verfahren oder einen anderen Strukturierungsprozess aufgebracht werden.

Die Halbleitermaterialien können auch mit geeigneten Hilfsmitteln (Polymere, Tenside) in disperser Phase durch Verdrucken verarbeitet werden.

In einer ersten bevorzugten Ausführungsform erfolgt die Abscheidung wenigstens einer Verbindung der allgemeinen Formel (I.A), (I.Ba), (I.Bb1) oder (I.Bb2) (und gegebenenfalls weiterer Halbleitermaterialien) durch ein Gasphasenabscheidungsverfahren (Physical Vapor Deposition PVD). PVD-Verfahren werden unter Hochvakuumbedingungen durchgeführt und umfassen die folgenden Schritte: Verdampfen, Transport, Abscheidung. Überraschenderweise wurde gefunden, dass sich die Verbindungen der allgemeinen Formel (I.A), (I.Ba), (I.Bb1) oder (I.Bb2) besonders vorteilhaft für einen Einsatz in einem PVD-Verfahren eignen, da sie sich im Wesentlichen nicht zersetzen und/oder unerwünschte Nebenprodukte bilden. Das abgeschiedene Material wird in hoher Reinheit erhalten. In einer speziellen Ausführung wird das abgeschiedene Material in Form von Kristallen erhalten oder enthält einen hohen kristallinen Anteil. Allgemein wird zur PVD wenigstens eine Verbindung der allgemeinen Formel (I.A), (I.Ba), (I.Bb1) oder (I.Bb2) auf eine Temperatur oberhalb ihrer Verdampfungstemperatur erhitzt und durch Abkühlen unterhalb der Kristallisationstemperatur auf einem Substrat abgeschieden. Die Temperatur des Substrats bei der Abscheidung liegt vorzugsweise in einem Bereich von etwa 20 bis 250 °C, besonders bevorzugt 50 bis 200 °C. Überraschenderweise wurde gefunden, dass erhöhte Substrattemperaturen bei der Abscheidung der Verbindungen der Formel (I.A), (I.Ba), (I.Bb1) oder (I.Bb2) vorteilhafte Auswirkungen auf die Eigenschaften der erzielten Halbleiterelemente haben können.

Die erhaltenen Halbleiterschichten weisen im Allgemeinen eine Dicke auf, die für einen ohmschen Kontakt zwischen Source- und Drain-Elektrode ausreicht. Die Abscheidung kann unter einer Inertatmosphäre, z. B. unter Stickstoff, Argon oder Helium, erfolgen.

Die Abscheidung erfolgt üblicherweise bei Umgebungsdruck oder unter reduziertem Druck. Ein geeigneter Druckbereich beträgt etwa 10⁻⁷ bis 1,5 bar.

Vorzugsweise wird die Verbindung der Formel (I.A), (I.Ba), (I.Bb1) oder (I.Bb2) auf dem Substrat in einer Dicke von 10 bis 1000 nm, besonders bevorzugt 15 bis 250 nm, abgeschieden. In einer speziellen Ausführung wird die Verbindung der Formel (I.A), (I.Ba), (I.Bb1) oder (I.Bb2) zumindest teilweise in kristalliner Form abgeschieden. Hierfür eignet sich speziell das zuvor beschriebene PVD-Verfahren. Weiterhin ist es möglich, zuvor hergestellte organische Halbleiterkristalle einzusetzen. Geeignete Verfahren zur Gewinnung von derartigen Kristallen werden von R. A. Laudise et al. in "Physical Vapor Growth of Organic Semi-Conductors", Journal of Crystal Growth 187 (1998), Seiten 449-454, und in "Physical Vapor Growth of Centimeter-sized Crystals of α-Hexathiophene", Journal of Cystal Growth 1982 (1997), Seiten 416-427, beschrieben, worauf hier Bezug genommen wird.

In einer zweiten bevorzugten Ausführungsform erfolgt die Abscheidung wenigstens einer Verbindung der allgemeinen Formel (I.A), (I.Ba), (I.Bb1) oder (I.Bb2) (und gegebenenfalls weiterer Halbleitermaterialien) durch eine Rotationsbeschichtung (spin coating). Überraschenderweise lassen sich die erfindungsgemäß verwendeten Verbindungen der Formel (I.A), (I.Ba), (I.Bb1) oder (I.Bb2) somit auch in einem Nassverarbeitungsverfahren (wet processing) zur Herstellung von Halbleitersubstraten einsetzen. Die Verbindungen der Formel (I.A), (I.Ba), (I.Bb1) oder (I.Bb2) sollten sich somit auch zur Herstellung von Halbleiterelementen, speziell OFETs oder auf der Basis von OFETs, durch ein Druckverfahren eignen. Es können dafür übliche Druckprozesse (Inkjet, Flexo, Offset, Gravur; Tiefdruck, Nanoprint) verwendet werden. Bevorzugte Lösungsmittel für den Einsatz der Verbindungen der Formel (I.A), (I.Ba), (I.Bb1) oder (I.Bb2) in einem Druckverfahren sind aromatische Lösungsmittel wie Toluol, Xylol, etc. Man kann zu diesen "Halbleitertinten" verdickend wirkende Substanzen, wie Polymere zusetzen, z. B. Polystyrol, etc. Dabei verwendet man als Dielektrikum die zuvor genannten Verbindungen.

In einer bevorzugten Ausführungsform handelt es sich bei dem erfindungsgemäßen Feldeffekttransistor um einen Dünnschichttransistor (thin film transistor, TFT). Gemäß einem üblichen Aufbau verfügt ein Dünnschichttransistor über eine auf dem Substrat befindliche Gate-Elektrode, eine auf dieser und dem Substrat befindliche Gate-Isolierschicht, eine auf der Gate-Isolierschicht befindliche Halbleiterschicht, eine ohmsche Kontaktschicht auf der Halbleiterschicht sowie über eine Source-Elektrode und eine Drain-Elektrode auf der ohmschen Kontaktschicht.

In einer bevorzugten Ausführungsform wird die Oberfläche des Substrats vor der Abscheidung wenigstens einer Verbindung der allgemeinen Formel (I.A), (I.Ba), (I.Bb1) oder (I.Bb2) (und gegebenenfalls wenigstens eines weiteren Halbleitermaterials) einer Modifizierung unterzogen. Diese Modifizierung dient der Bildung von die Halbleitermaterialien bindenden Bereichen und/oder von Bereichen, auf denen keine Halbleitermaterialien abgeschieden werden können. Bevorzugt wird die Oberfläche des Substrats mit wenigstens einer

Verbindung (C1) modifiziert, die geeignet ist, an die Oberfläche des Substrats sowie an die Verbindungen der Formel (I.A), (I.Ba), (I.Bb1) oder (I.Bb2) zu binden. In einer geeigneten Ausführungsform wird ein Teil der Oberfläche oder die komplette Oberfläche des Substrats mit wenigstens einer Verbindung (C1) beschichtet, um eine verbesserte Abscheidung wenigstens einer Verbindung der allgemeinen Formel (I.A), (I.Ba), (I.Bb1) oder (I.Bb2) (und gegebenenfalls weiterer halbleitender Verbindungen) zu ermöglichen. Eine weitere Ausführungsform umfasst die Abscheidung eines Musters von Verbindungen der allgemeinen Formel (C1) auf dem Substrat nach einem entsprechenden Herstellungsverfahren. Dazu zählen die dafür bekannten Maskenprozesse sowie sogenannte "Patterning"-Verfahren, wie sie z. B. in US 11/353,934 beschrieben sind, worauf hier in vollem Umfang Bezug genommen wird.

Geeignete Verbindungen der Formel (C1) sind zu einer bindenden Wechselwirkung sowohl mit dem Substrat als auch mit wenigstens einer Halbleiterverbindung der allgemeinen Formel (I.A), (I.Ba), (I.Bb1) oder (I.Bb2) befähigt. Der Begriff "bindende Wechselwirkung" umfasst die Bildung einer chemischen Bindung (kovalenten Bindung), ionischen Bindung, koordinativen Wechselwirkung, Van der Waals-Wechselwirkungen, z. B. Dipol-Dipol-Wechselwirkungen) etc. und Kombinationen davon. Geeignete Verbindungen der allgemeinen Formel (C1) sind:
- Silane, Phosphonsäuren, Carbonsäuren, Hydroxamsäuren, wie Alkyltrichlorsilane, z. B. n-(Octadecyl)trichlorsilan; Verbindungen mit Trialkoxysilan-Gruppen, z. B. Alkyltrialkoxysilane, wie n-Octadecyltrimethoxysilan, n-Octadecyltriethoxysilan, n-Octadecyltri-(n-propyl)oxysilan, n-Octadecyltri-(isopropyl)oxysilan; Trialkoxyaminoalkylsilane, wie Triethoxyaminopropylsilan und N[(3-triethoxysilyl)-propyl]-ethylen-diamin; Trialkoxyalkyl-3-glycidylethersilane, wie Triethoxypropyl-3-glycidylethersilan; Trialkoxyallylsilane wie Allyltrimethoxysilan; Trialkoxy-(isocyanatoalkyl)silane; Trialkoxysilyl(meth)acryloxyalkane und Trialkoxysilyl-(meth)acrylamidoalkane, wie 1-Triethoxysilyl-3-acryloxypropan.
- Amine, Phosphine und Schwefel enthaltende Verbindungen, speziell Thiole.

Bevorzugt ist die Verbindung (C1) ausgewählt unter Alkyltrialkoxysilanen, speziell n-Octadecyltrimethoxysilan, n-Octadecyltriethoxysilan; Hexaalkyldisilazanen, und speziell Hexamethyldisilazan (HMDS); C₈-C₈₀-Alkylthiolen, speziell Hexadecanthiol; Mercaptocarbonsäuren und Mercaptosulfonsäuren, speziell Mercaptoessigsäure, 3-Mercaptopropionsäure, Mercaptobernsteinsäure, 3-Mercapto-1-propansulfonsäure und den Alkalimetall- und Ammoniumsalzen davon.

Es sind auch verschiedene Halbleiterarchitekturen mit den erfindungsgemäßen Halbleitern denkbar wie z. B. Top Contact, Top Gate, Bottom Contact, Bottom Gate, oder aber ein vertikaler Aufbau wie z. B. ein VOFET (Vertical organic field effect transistor) wie z. B. in US 2004/0046182 beschrieben.

Die Schichtdicken betragen bei Halbleitern z. B. 10 nm bis 5 µm, beim Dielektrikum 50 nm bis 10 µm, die Elektroden können z. B. 20 nm bis 1 µm dick sein. Die OFETs können auch zu anderen Bauteilen wie Ringoszillatoren oder Inverter kombiniert werden.

Ein weiterer Aspekt der Erfindung ist die Bereitstellung elektronischer Bauteile, die mehrere Halbleiterkomponenten umfassen, wobei es sich um n- und/oder p-Halbleiter handeln kann. Beispiele solcher Bauteile sind Feldeffekttransistoren (FETs), bipolare Flächentransistoren (bipolar junction transistors, BJTs), Tunneldioden, Wechselrichter, lichtemittierende Bauteile, biologische und chemische Detektoren oder Sensoren, Temperatur-abhängige Detektoren, Photodetektoren wie Polarisations-sensitive Photodetektoren, Gatter, AND-, NAND-, NOT-, OR-, TOR-, und NOR-Gatter, Register, Schalter, Zeitbausteine, statische oder dynamische Speicher und andere dynamische oder sequentielle logische oder andere digitale Bauteile einschließlich programmierbarer Schaltungen.

Ein spezielles Halbleiterelement ist ein Inverter. In der digitalen Logik ist der Inverter ein Gatter, das ein Eingangssignal invertiert. Der Inverter wird auch als NOT-Gate bezeichnet. Reale Inverterschaltungen weisen einen Ausgangsstrom auf, der das Gegenteil zum Eingangsstrom darstellt. Übliche Werte sind z. B. (0, +5V) für TTL-Schaltungen. Die Leistungsfähigkeit eines digitalen Inverters gibt die Spannungstransferkurve (Voltage Transfer Curve VTC) wieder, d. h. der Auftrag von Inputstrom gegen Outputstrom. Idealerweise handelt es sich um eine Stufenfunktion und je näher sich die real gemessene Kurve einer solchen Stufe annähert, desto besser ist der Inverter. In einer speziellen Ausführung der Erfindung werden die Verbindungen der Formel (I.A), (I.Ba), (I.Bb1) oder (I.Bb2) als organischer n-Halbleiter in einem Inverter eingesetzt.

Die Verbindungen der Formel (I.A), (I.Ba), (I.Bb1) oder (I.Bb2) eignen sich weiterhin besonders vorteilhaft für einen Einsatz in der organischen Photovoltaik (OPV). Bevorzugt eignen sich diese Verbindungen für einen Einsatz in Solarzellen, die durch eine Diffusion von angeregten Zuständen (Excitonendiffusion) gekennzeichnet sind. Dabei zeichnet sich eines oder beide der eingesetzten Halbleitermaterialien durch eine Diffusion von angeregten Zuständen (Excitonenbeweglichkeit) aus. Geeignet ist auch die Kombination wenigstens eines Halbleitermaterials, das durch eine Diffusion von angeregten Zuständen gekennzeichnet ist, mit Polymeren, die eine Leitung der angeregten

Zustände entlang der Polymerkette zulassen. Derartige Solarzellen werden im Sinne der Erfindung als excitonische

Solarzellen bezeichnet. Die Direktumwandlung von Solarenergie in elektrische Energie in Solarzellen beruht auf dem inneren Photoeffekt eines Halbleitermaterials, d. h. der Erzeugung von Elektron-Loch-Paaren durch Absorption von Photonen und der Trennung der negativen und positiven Ladungsträger an einem p-n-Übergang oder einem Schottky-Kontakt. Ein Exciton kann z. B. entstehen, wenn ein Photon in einen Halbleiter eindringt und ein Elektron zum Übergang aus dem Valenzband in das Leitungsband anregt. Um Strom zu erzeugen, muss der durch die absorbierten Photonen erzeugte angeregte Zustand jedoch einen p-n-Übergang erreichen, um ein Loch und ein Elektron zu erzeugen, welches dann zur Anode und Kathode fließt. Die so erzeugte Photospannung kann in einem äußeren Stromkreis einen Photostrom bewirken, durch den die Solarzelle ihre Leistung abgibt. Von dem Halbleiter können dabei nur solche Photonen absorbiert werden, die eine Energie aufweisen, die größer als seine Bandlücke ist. Die Größe der Halbleiterbandlücke bestimmt also den Anteil des Sonnenlichts, der in elektrische Energie umgewandelt werden kann. Solarzellen bestehen normalerweise aus zwei absorbierenden Materialien mit unterschiedlichen Bandlücken, um die Sonnenenergie möglichst effektiv zu nutzen. Die meisten organischen Halbleiter haben Excitonen-Diffusionslängen von bis zu 10 nm. Hier besteht weiterhin ein Bedarf an organischen Halbleitern, über die der angeregte Zustand über möglichst große Distanzen weitergeleitet werden kann. Überraschenderweise wurde nun gefunden, dass sich die zuvor beschriebenen Verbindungen der allgemeinen Formel (I.A), (I.Ba), (I.Bb1) oder (I.Bb2) besonders vorteilhaft für einen Einsatz in excitonischen Solarzellen eignen.

Geeignete organische Solarzellen sind in der Regel schichtförmig aufgebaut und umfassen in der Regel zumindest die folgenden Schichten: Anode, photoaktive Schicht und Kathode. Diese Schichten befinden sich in der Regel auf einem dafür üblichen Substrat. Der Aufbau organischer Solarzellen ist z. B. in US 2005/0098726 A1 und US 2005/0224905 A1 beschrieben, worauf hier in vollem Umfang Bezug genommen wird.

Geeignete Substrate sind z. B. oxidische Materialien (wie Glas, Keramik, SiO₂, insbesondere Quarz, etc.), Polymere (z. B. Polyvinylchlorid, Polyolefine, wie Polyethylen und Polypropylen, Polyester, Fluorpolymere, Polyamide, Polyurethane, Polyalkyl(meth)-acrylate, Polystyrol und Mischungen und Komposite davon) und Kombinationen davon.

Als Elektroden (Kathode, Anode) eignen sich prinzipiell Metalle (vorzugsweise der Gruppen 2, 8, 9, 10, 11 oder 13 des Periodensystems, z. B. Pt, Au, Ag, Cu, Al, In, Mg, Ca), Halbleiter (z. B. dotiertes Si, dotiertes Ge, Indium-Zinn-Oxid (ITO), Gallium-Indium-Zinn-Oxid (GITO), Zink-Indium-Zinn-Oxid (ZITO), etc.), Metalllegierungen (z. B. auf Basis Pt, Au, Ag, Cu, etc., speziell Mg/Ag-Legierungen), Halbleiterlegierungen, etc. Bevorzugt wird als Anode ein gegenüber einfallendem Licht im Wesentlichen transparentes Material eingesetzt. Dazu zählt z. B. ITO, dotiertes ITO, ZnO, TiO₂, Ag, Au, Pt. Bevorzugt wird als Kathode ein das einfallende Licht im Wesentlichen reflektierendes Material eingesetzt. Dazu zählen z. B. Metallfilme, z. B. aus Al, Ag, Au, In, Mg, Mg/Al, Ca, etc.

Die photoaktive Schicht ihrerseits umfasst wenigstens eine oder besteht aus wenigstens einer Schicht, die als organisches Halbleitermaterial wenigsten eine Verbindung enthält, die ausgewählt ist unter Verbindungen der Formel (I.A), (I.Ba), (I.Bb1) oder (I.Bb2), wie zuvor definiert. In einer Ausführung umfasst die photoaktive Schicht wenigstens ein organisches Akzeptormaterial. Zusätzlich zu der photoaktiven Schicht kann es eine oder mehrere weitere Schichten geben, z. B. eine Schicht mit Elektronen leitenden Eigenschaften (ETL, electron transport layer) und eine Schicht, die ein löcherleitendes Material (hole transport layer, HTL) enthält, die nicht absorbieren müssen, Excitonen und Löcher blockierende Schichten (z. B. excition blocking layers, EBL), die nicht absorbieren sollen, Multiplikatorschichten (multiplication layers). Geeignete Excitonen und Löcher blockierende Schichten sind z. B. in US 6,451,415 beschrieben.

Geeignete Excitonenblockerschichten sind z. B. Bathocuproine (BCP), 4,4',4"-Tris[3-methylphenyl(phenyl)amino]triphenylamin (m-MTDATA) oder Polyethylendioxythiophen (PEDOT), wie in US 7,026,041 beschrieben.

Die erfindungsgemäßen excitonischen Solarzellen basieren auf photoaktiven Donor-Akzeptor-Heteroübergängen. Wird wenigstens eine Verbindung der Formel (I.A), (I.Ba), (I.Bb1) oder (I.Bb2) als HTM (hole transport material, Lochtransportmaterial) eingesetzt, muss das entsprechende ETM (exciton transport material, Excitonentransportmaterial) so gewählt werden, dass nach Anregung der Verbindungen ein schneller Elektronenübergang auf das ETM stattfindet. Geeignete ETM sind z. B. C60 und andere Fullerene, Perylen-3,4:9,10-bis(dicarboximide) (PTCDI), etc. Wird wenigstens eine Verbindung der Formel (I.A), (I.Ba), (I.Bb1) oder (I.Bb2) als ETM eingesetzt, muss das komplementäre HTM so gewählt werden, dass nach Anregung der Verbindung ein schneller Löcherübertrag auf das HTM stattfindet. Der Heteroübergang kann flach ausgeführt werden (vgl. Two layer organic photovoltaic cell, C. W. Tang, Appl. Phys. Lett., 48 (2), 183-185 (1986) oder N. Karl, A. Bauer, J. Holzäpfel, J. Marktanner, M. Möbus, F. Stölzle, Mol. Cryst. Liq. Cryst., 252, 243-258 (1994).) oder als Volumen-Heteroübergang (bulk heterojunction bzw. interpenetrierenes Donorakzeptor-Netzwerk, vgl. z. B. C. J. Brabec, N. S. Sariciftci, J. C. Hummelen, Adv. Funct. Mater., 11 (1), 15 (2001).) realisiert werden. Die photoaktive Schicht auf Basis eines Heteroübergangs zwischen wenigstens eine Verbindung der Formel (I.A), (I.Ba), (I.Bb1) oder (I.Bb2) und einem HTL (hole transport layer, Lochtransportschicht) oder ETL (exciton transport layer,

Excitontransportschicht) kann in Solarzellen mit MiM-, pin-, pn-, Mip- oder Min-Aufbau zum Einsatz kommen (M = Metall, p = p-dotierter organischer oder anorganischer Halbleiter, n = n-dotierter organischer oder anorganischer Halbleiter, i = intrinsisch leitfähiges System organischer Schichten, vgl. z. B. J. Drechsel et al., Org. Eletron., 5 (4), 175 (2004) oder Maennig et al., Appl. Phys. A 79, 1-14 (2004)). Sie kann auch in Tandemzellen, wie von P. Peumnas, A. Yakimov, S. R. Forrest in J. Appl. Phys, 93 (7), 3693-3723 (2003) (vgl. Patente US 4,461,922, US 6,198,091 und US 6,198,092) beschrieben, verwendet werden. Sie kann auch in Tandemzellen aus zwei oder mehreren aufeinandergestapelten MiM-, pin-, Mip- oder Min-Dioden (vgl. Patentanmeldung DE 103 13 232.5) verwendet werden (J. Drechsel et al., Thin Solid Films, 451452, 515-517 (2004)).

Dünne Schichten der Verbindungen und aller anderer Schichten können durch Aufdampfen im Vakuum oder in Inertgasatmosphäre, durch Laserablation oder durch lösungs- oder dispersionsprozessierbare Verfahren wie Spin-Coating, Rakeln, Gießverfahren, Aufsprühen, Tauchbeschichtung oder Drucken (z. B. Inkjet, Flexo, Offset, Gravur; Tiefdruck, Nanoimprint) hergestellt werden. Die Schichtdicken der M, n, i und p-Schichten betragen typischerweise 10 bis 1000 nm, bevorzugt 10 bis 400 nm.

Als Substrat werden z. B. Glas, Metall- oder Polymerfolien verwendet, die in der Regel mit einer transparenten, leitfähigen Schicht (wie z. B. SnO₂:F, SnO₂:In, ZnO:Al, Carbon-Nanotubes, dünne Metallschichten) beschichtet sind.

Neben den Verbindungen der allgemeinen Formel (I.A), (I.Ba), (I.Bb1) oder (I.Bb2) eignen sich die folgenden Halbleitermaterialien für einen Einsatz in der organischen Photovoltaik:
Phthalocyanine, beispielsweise Phthalocyanine, die wenigstens einen Halogensubstituenten tragen, wie Hexadecachlorophthalocyanine und Hexadecafluorophthalocyanine, metallfreie oder zweiwertige Metalle oder Metallatom-haltige Gruppen enthaltende Phthalocyanine, insbesondere die des Titanyloxy, Vanadyloxy, Eisens, Kupfers, Zinks, etc. Geeignete Phthalocyanine sind insbesondere Kupferphthalocyanin, Zinkphthalocyanin, metallfreies Phthalocyanin, Hexadecachlorokupferphthalocyanin, Hexadecachlorozinkphthalocyanin, metallfreies Hexadecachlorophathlocyanin, Hexadecafluorokupferphthalocyanin, Hexadecafluorophthalocyanin oder metallfreies Hexadefluorophthalocyanin;
Porphyrine, wie z. B. 5,10,15,20-Tetra(3-pyridyl)porphyrin (TpyP), oder aber Tetrabenzoporphyrine wie z. B. metallfreies Tetrabenzoporphyrin, Kupfertetrabenzoprophyrin oder Zinktetrabenzoporphyrin.
Flüssigkristalline (LC)-Materialien, beispielsweise Coronene, wie Hexabenzocoronen (HBC-PhC₁₂), Coronendiimide, oder Triphenylene, wie 2,3,6,7,10,11 Hexahexylthiotriphenylen (HTT₆), 2,3,6,7,10,11-Hexakis-(4-n-nonyhphenyl)-triphenylen (PTP₉) oder 2,3,6,7,10,11-Hexakis-(undecyloxy)-triphenylen (HAT₁₁). Besonders bevorzugt sind flüssigkristalline Materialien, die diskotisch sind;
Thiophene, Oligothiophene und substituierte Derivate davon. Geeignete Oligothiophene sind Quaterthiophene, Quinquethiophene, Sexithiophene, α,ω-Di(C₁-C₈)-alkyloligothiophene, wieα,ω-Dihexyiquaterthiophene, α,ω-Dihexyiquinquethiophene und α,ω-Dihexyisexithiophene, Poly(alkylthiophene), wie Poly(3-hexylthiophen), Bis(dithienothiophene), Anthradithiophene und Dialkylanthradithiophene, wie Dihexylanthradithiophen, Phenylene-Thiophen-(P-T)-Oligomere und Derivate davon, speziell α,ω-Alkyl-substituierte Phenylen-Thiophen-Oligomere;
Geeignet sind weiterhin Verbindungen des Typs α,α'-Bis(2,2 dicyanovinyl)quinquethiophen (DCV₅T), Poly[3-(4 Octylphenyl)-2,2'-bithiophen] (PTOPT), Poly(3-(4'-(1,4,7-trioxaoctyl)phenyl)thiophen (PEOPT), (Poly(3-(2'-methoxy-5'-octylphenyl)thiophen)) (POMeOPT), Poly(3 octylthiophen) (P3OT), Poly(pyridopyrazinvinylen)-Polythiophen-Blends, wie EHH-PpyPz, Copolymere PTPTB, BBL, Poly(9,9-dioctylfluoren-co-bis-N,N'-(4-methoxyphenyl)-bis-N,N'-phenyl-1,4-phenylendiamin) (PFMO), siehe Brabec C., Adv. Mater., 2996, 18, 2884, (PCPDTBT) Poly[2,6-(4,4-bis-(2-ethylhexyl)-4H-cyclo¬penta[2,1 b;3,4 b']-dithiophen)-4,7-(2,1,3-benzothiadiazol);
Paraphenylenvinylen und Paraphenylenvinylen enthaltende Oligomere oder Polymere wie z. B. Polyparaphenylenvinylen (PPV), MEH-PPV (Poly(2-methoxy-5-(2'-ethylhexyloxy)-1,4-phenylenevinylen, MDMO-PPV (Poly(2-methoxy-5-(3',7'-dimethyloctyloxy)-1,4-phenylen-vinylen)), Cyano-Paraphenylenvinylen (CN-PPV), CN-PPV modifiziert mit verschiedenen Alkoxy-Gruppen;
Phenylenethinylen/Phenylenvinylen-Hybridpolymere (PPE-PPV);
Polyfluorene und alternierende Polyfluoren-Copolymere wie z. B. mit 4,7-Dithien-2'-yl-2,1,3-benzothiadiazol; Geeignet sind weiterhin Poly(9,9'-dioctylfluoren-co-benzothio¬diazol) (F₈BT), Poly(9,9'-dioctylfluoren-co-bis-N,N'-(4-butyl-phenyl)-bis-N,N'-phenyl-1,4-phenylendiamin (PFB);
Polycarbazole, d. h. Carbazol enthaltende Oligomere und Polymere, wie (2,7) und (3,6).
Polyaniline, d. h. Anilin enthaltende Oligomere und Polymere.

Triarylamine, Polytriarylamine, Polycyclopentadiene, Polypyrrole, Polyfurane, Polysilole, Polyphosphole, N,N'-Bis-(3-methylphenyl)-N,N'-bis-(phenyl)-benzidin (TPD), 4,4'-Bis(carbazol-9-yl)biphenyl (CBP), 2,2',7,7'-Tetrakis-(N,N-di-p-methoxyphenylamin)-9,9'-spirobifluoren (Spiro-MeOTAD).

Fullerene, speziell C₆₀ und seine Derivate wie PCBM (= [6,6]-Phenyl-C₆₁-buttersäure-methylester). In derartigen Fällen ist das Fullerenderivat ein Lochleiter.

Alle zuvor genannten Halbleitermaterialien können auch dotiert sein. Beispiele geeigneter Dotierstoffe für n-Halbleiter der Verbindungen der Formel (I.A), (I.Ba), (I.Bb1) oder (I.Bb2) sind beispielsweise Rhodamin oder Pyronin B. Beispiele geeigneter Dotierstoffen für p-Halbleiter sind 2,3,5,6-Tetrafluoro-7,7,8,8-tetra-cyanochinodimethan (F₄-TCNQ).

Ein weiterer Gegenstand der Erfindung betrifft eine organische Leuchtdiode (OLED), die wenigstens eine Verbindung der allgemeinen Formel (I.A), (I.Ba), (I.Bb1) oder (I.Bb2), wie zuvor definiert, enthält. Die Verbindungen der Formel (I.A), (I.Ba), (I.Bb1) oder (I.Bb2) können dabei als Ladungstransportmaterial (Elektronenleiter) dienen.

Organische Leuchtdioden sind grundsätzlich aus mehreren Schichten aufgebaut. Dazu zählen: 1. Anode 2. Löcher-transportierende Schicht 3. lichtemittierende Schicht 4. Elektronen-transportierende Schicht 5. Kathode. Es ist auch möglich, dass die organische Leuchtdiode nicht alle der genannten Schichten aufweist, zum Beispiel ist eine organische Leuchtdiode mit den Schichten (1) (Anode), (3) (lichtemittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet. Der Aufbau von organischen Leuchtdioden und Verfahren zu ihrer Herstellung sind dem Fachmann prinzipiell bekannt, z. B. aus der WO 2005/019373. Geeignete Materialien für die einzelnen Schichten von OLEDs sind z. B. in WO 00/70655 offenbart. Auf die Offenbarung dieser Dokumente wird hier Bezug genommen. Die Herstellung von erfindungsgemäßen OLEDs kann nach dem Fachmann bekannten Methoden erfolgen. Im Allgemeinen wird eine OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben einer Verbindung der allgemeinen Formel (I.A), (I.Ba), (I.Bb1) oder (I.Bb2) ein polymeres Material in einer der Schichten der OLEDs, bevorzugt in der lichtemittierenden Schicht, aufweisen, werden im Allgemeinen durch Verarbeitung aus Lösung als Schicht aufgebracht.

Durch die erfindungsgemäße Verwendung der Verbindungen (I.A), (I.Ba), (I.Bb1) oder (I.Bb2) können OLEDs mit hoher Effizienz erhalten werden. Die erfindungsgemäßen OLEDs können in allen Vorrichtungen eingesetzt werden, bei denen Elektrolumineszenz nützlich ist. Geeignete Vorrichtungen sind bevorzugt ausgewählt aus stationären und mobilen Bildschirmen. Stationäre Bildschirme sind z. B. Bildschirme von Computern, Fernsehern, Bildschirme in Druckern, Küchengeräten sowie Reklametafeln, Beleuchtungen und Hinweistafeln. Mobile Bildschirme sind z. B. Bildschirme in Handys, Laptops, Digitalkameras, Fahrzeugen sowie Zielanzeigen an Bussen und Bahnen. Weiterhin können die Verbindungen (I.A), (I.Ba), (I.Bb1) oder (I.Bb2) in OLEDs mit inverser Struktur eingesetzt werden. Bevorzugt werden die Verbindungen (I.A), (I.Ba), (I.Bb1) oder (I.Bb2) in diesen inversen OLEDs wiederum in der lichtemittierenden Schicht eingesetzt. Der Aufbau von inversen OLEDs und die üblicherweise darin eingesetzten Materialien sind dem Fachmann bekannt.

Vor ihrem Einsatz als Ladungstransportmaterialien oder Excitonentransportmaterialien kann es sinnvoll sein, die Verbindungen der Formel (I.A), (I.Ba), (I.Bb1) oder (I.Bb2) einem Reinigungsverfahren zu unterziehen. Geeignete Reinigungsverfahren umfassen ein Überführen der Verbindungen der Formel (I.A), (I.Ba), (I.Bb1) oder (I.Bb2) in die Gasphase. Dazu zählen die Reinigung durch Sublimation oder PVD (physical vapor deposition). Bevorzugt ist eine fraktionierte Sublimation. Zur fraktionierten Sublimation und/oder Abscheidung der Verbindung wird ein Temperaturgradient eingesetzt. Vorzugsweise wird die Verbindung der Formel (I.A), (I.Ba), (I.Bb1) oder (I.Bb2) unter Erhitzen in einem Trägergasstrom sublimiert. Das Trägergas strömt dann durch eine Trennkammer. Eine geeignete Trennkammer weist wenigstens zwei verschiedene Trennzonen mit unterschiedlichen Temperaturen auf. Bevorzugt wird ein so genanntes "threezone furnace" eingesetzt. Ein geeignetes Verfahren und eine Vorrichtung zur fraktionierten Sublimation ist in der US 4,036,594 beschrieben.

Ein weiterer Gegenstand der Erfindung ist ein Verfahren zur Abscheidung oder Auftragung wenigstens einer Verbindung der Formel (I.A), (I.Ba), (I.Bb1) oder (I.Bb2) auf ein(em) Substrat durch ein Gasphasenabscheidungsverfahren oder ein Nassauftragungsverfahren.

Die Erfindung wird anhand der folgenden, nicht einschränkenden Beispiele näher erläutert.

### Beispiele

### Synthesebeispiele:

### Beispiel 1: Herstellung von Octafluor-N,N'-dimethylperylen-3,4:9,10-tetracarbonsäurediimid (nicht erfindungsgemäß)

### 1.a) Herstellung von Octachlor-N,N'-dimethylperylen-3,4:9,10-tetracarbonsäurediimid

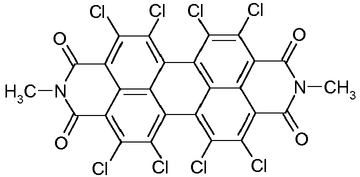

Zu einer Lösung von N,N'-Dimethylperylen-3,4:9,10-tetracarbonsäurediimid (20,9 g, 0,05 mol) in Chlorsulfonsäure (200 g) wurde bei 80 °C über einen Zeitraum von 28 Stunden Chlor (ca. 500 g) eingeleitet. Über diesen Zeitraum wurde Iod (10 g) portionsweise zugesetzt. Das erhaltene Reaktionsgemisch wurde abgekühlt und auf Eiswasser gegeben. Der dabei ausfallende Feststoff wurde abfiltriert und bis zur pH-Neutralität des Filtrats gewaschen. Nach Trocknen am Vakuum wurde Octachlor-N,N'-dimethylperylen-3,4:9,10-tetracarbonsäurediimid als orangefarbener Feststoff erhalten (28,8 g; Ausbeute 83 %).

Durch Umkristallisation aus Toluol wurde die Verbindung weiter aufgereinigt. Dazu wurden 4,0 g des Rohproduktes in Toluol (1,1 l) unter Rückfluss erhitzt und mehrere Tage auf 0 °C gekühlt. Der ausgefallene Niederschlag wurde abfiltriert und im Vakuum getrocknet. Man erhielt 3,21 g der aufgereinigten Verbindung.

### 1.b) Herstellung von Octafluor-N,N-dimethylperylen-3,4:9,10-tetracarbonsäurediimid

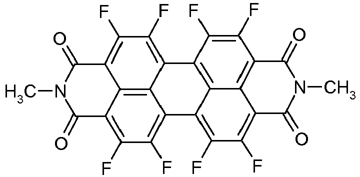

Zu einem Gemisch aus Sulfolan (250 ml), 18-Krone-6-ether (11,4 g, 43,2 mmol) und Kaliumfluorid (7,3 g, 125 mmol) wurde bei 180 °C N,N'-Dimethyl-octachlorperylen-3,4:9,10-tetracarbonsäurediimid (3,1 g, 5 mmol) zugegeben. Das Reaktionsgemisch wurde eine weitere Stunde bei dieser Temperatur gerührt. Nach Abkühlen auf Raumtemperatur wurde vollentsalztes Wasser zugegeben. Der ausfallende Feststoff wurde abfiltriert und mit vollentsalztem Wasser gewaschen und getrocknet. Das erhaltene Produkt wurde durch Säulenchchromatographie (SiO₂, Toluol/Essigester, 10 : 1) gereinigt. Octafluor-N,N-Dimethylperylen-3,4:9,10-tetracarbonsäurediimid wurde als bräunlich gelber Feststoff in einer Menge von 45 mg erhalten (Ausbeute 1,5 %).
R_{f} (Toluol/Ethylacetat; 10 : 1) = 0,19.
λ ₘₐₓ Emission (hohe Verdünnung, CH₂Cl₂) = 481 nm, 515 nm
λ ₘₐₓ Absorption (CH₂Cl₂) = ca. 408 nm (20,9 l/g cm), 435 nm (47,9 l/g cm), 466 nm (ca. 65,8 l/g cm)

### 1.c) Alternative Route zur Herstellung von Octafluor-N,N-dimethylperylen-3,4:9,10-tetracarbonsäurediimid

Zu einer Mischung von 166 ml o-Xylol, 1,7 g (6,7 mmol) (N,N'-Dimethylimidazolidino)-tetramethylguanidiniumchlorid und 30,0 g (533 mmol) Kaliumfluorid wurden 4,63 g (6,7 mmol) Octachlor-N,N'-dimethylperylen-3,4:9,10-tetracarbonsäurediimid aus Beispiel 1a gegeben. Das Reaktionsgemisch wurde 30 Minuten am Rückfluss erhitzt. Danach ließ man das Reaktionsgemisch auf Raumtemperatur abkühlen und isolierte das Produkt direkt aus dem Reaktionsgemisch durch Säulenchromatographie an 180 g Kieselgel unter Verwendung von Petrolether und Dichlormethan. Man erhielt nach wiederholter Chromatographie 1,55 g (41 %) der Titelverbindung mit einer Reinheit von 98% sowie 0,6 g (16%) der Titelverbindung mit einer Reinheit von 94%.

Man erhielt die Titelverbindung in sehr hoher Reinheit durch mehrfache Chromatographie mit einer Flussrate von 101 l/g unter UV/VIS-Detektion bei 469 nm.

### Beispiel 2: Herstellung von Octachlorperylen-3,4:9,10-tetracarbonsäurediimid

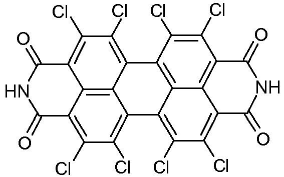

Zu einer Lösung von Perylen-3,4:9,10-tetracarbonsäurediimid (19,5 g, 0,05 mol) in Chlorsulfonsäure (200 g) wurde Iod (2,0 g) gegeben. Das Reaktionsgemisch wurde auf 80 °C erhitzt. Über einen Zeitraum von 25 Stunden wurde Chlor (ca. 445 g) eingeleitet. Nach Abkühlen auf Raumtemperatur wurde das Reaktionsgemisch auf Eis gegeben. Der ausfallende Feststoff wurde abfiltriert und mehrmals mit Wasser gewaschen. Nach Trocknen am Vakuum wurde Octachlor-N,N'-Dihydroperylen-3,4:9,10-tetracarbonsäurediimid als orangefarbener Feststoff in einer Menge von 26,14 g erhalten (Ausbeute 79 %).

Das Produkt wurde durch Umkristallisation weiter aufgereinigt. Hierzu wurden 4,0 g des Rohproduktes in N-Methylpyrrolidon (NMP, 70 ml) bei 140 °C gelöst und das Gemisch langsam auf Raumtemperatur abgekühlt. Der Niederschlag wurde durch Filtration isoliert, mit Petrolether gewaschen und am Vakuum getrocknet. Anschließend wurde der Rückstand mehrer Tage in Essigsäure aufgenommen und unter Rückflussbedingungen gerührt. Nach erneuter Filtration und Trocknen wurden 0,81 g aufgereinigtes Octachlor-N,N'-Dihydroperylen-3,4:9,10-tetracarbonsäurediimid erhalten (Chlorgehalt: 42,7 % (theor.: 42,6 %)).

### Beispiel 3: Herstellung von Perchlorperylen-3,4:9,10-tetracarbonsäuredianhydrid

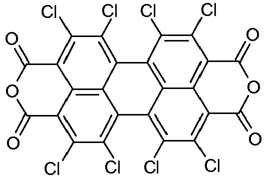

Zu einer Lösung von Perylen-3,4:9,10-tetracarbonsäureanhydrid (20,0 g) in Chlorsulfonsäure (200 g) wurde Iod (1,0 g) gegeben. Das Reaktionsgemisch wurde auf 60 °C erhitzt. Über einen Zeitraum von 7 Stunden wurde Chlor (ca. 120 g) eingeleitet. Anschließend wurde erneut Iod (1,0 g) zugesetzt, auf 80 °C erhitzt und über einen Zeitraum von 5 Stunden weiteres Chlor eingeleitet. Nach Abkühlen auf Raumtemperatur wurde das Reaktionsgemisch auf Eiswasser gegossen. Der ausfallende Feststoff wurde abfiltriert und bis zur pH-Neutralität des Filtrats gewaschen. Nach Trocknen am Vakuum wurde Octachlorperylen-3,4:9,10-tetracarbonsäureanhydrid als orangefarbener Feststoff erhalten (29,8 g; Ausbeute 89 %).

### Beispiel 4: Herstellung von Verbindungen (4.a) und (4.b)

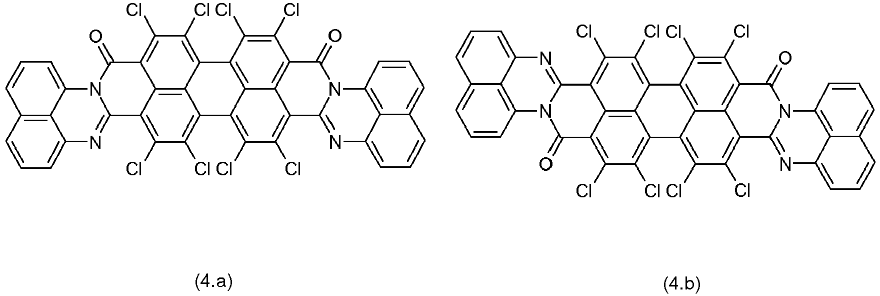

Ein Gemisch aus 1,8-Diaminonapthalin (1,78 g, 11,25 mmol), Pyrazin (0,9 g, 11,25 mmol) und Perchloroperylen-3,4:9,10-tetracarbonsäureanhydrid (3,0 g, 4,5 mmol) in Phenol (50 g) wurde 36 Stunden bei einer Temperatur von 120 °C gerührt. Anschließend wurde das Reaktionsgemisch auf Raumtemperatur abgekühlt und mit Methanol versetzt. Der Feststoff wurde abfiltriert, mehrfach mit Methanol und verdünnter Salzsäure gewaschen und anschließend getrocknet. Ein Gemisch der Verbindungen (4.a) und (4.b) wurde als schwarzer Feststoff in einer Menge von 3,97 g erhalten (quantitative Ausbeute).

### Beispiel 5: Herstellung von Octachlor-N,N'-bis(2,6-diisopropylphenyl)-perylen-3,4:9,10-tetracarbonsäurediimid

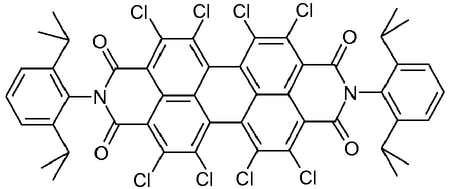

Ein Gemisch von Octachlorperylen-3,4:9,10-tetracarbonsäuredianhydrid (1,0 g, 1,5 mmol) und 2,6-DÜsopropylanilin (6 mmol) in Propionsäure (16 ml) wurde 5 Stunden bei einer Temperatur von 100 °C gerührt. Nach Abkühlen auf Raumtemperatur wurde das das Reaktionsgemisch mit Wasser versetzt. Der dabei ausfallende Feststoff wurde abfiltriert und im Vakuum getrocknet. Das so erhaltene Rohprodukt wurde durch Säulenchromatographie (SiO₂, Dichlormethan) aufgereinigt. Octachlor-N,N'-Bis(2,6-diisopropylphenyl)-perylen-3,4:9,10-tetracarbonsäurediimid wurde als orangefarbener Feststoff in einer Menge von 0,6 g erhalten (Ausbeute 40 %). R_{f} (SiO₂, Toluol/-Essigester, 10 : 1) = 0,86.

### Beispiel 6: Herstellung von Octachlor-N,N'-bis(1H,1H-perfluorbutyl)-perylen-3,4:9,10-tetracarbonsäurediimid

### 6.a) Herstellung von N,N'-Bis(1H,1H-perfluorobutyl)-1,6,7,12-tetrachloroperylen-3,4:9,10-tetracarbonsäurediimid (nicht erfindungsgemäß)

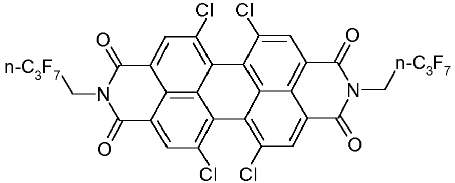

Ein Gemisch von 1,6,7,12-Tetrachloroperylen-3,4:9,10-tetracarbonsäuredianhydrid (9,38 g, 17,7 mmol) und 1H,1H-Heptafluoro-n-butylamin (9,88 g, 49,6 mmol) in N-Methylpyrrolidon (NMP, 100 ml) und Essigsäure (6,4 g, 106 mmol) wurde 5 h bei einer Temperatur von 90 °C gerührt. Nach Abkühlen auf Raumtemperatur wurde das Reaktionsgemisch auf verdünnte Salzsäure (250 ml) gegeben. Der dabei ausfallende Feststoff wurde abfiltriert, mit Wasser bis zur pH-Neutralität des Filtrats gewaschen und im Vakuum trocknet. Man erhielt einen orangefarbenen Feststoff (14,3 g), der durch Säulenchromatographie (SiO₂, Toluol/Aceton) aufgereinigt wurde.

N,N'-Bis(1H,1H-perfluorobutyl)-1,6,7,12-tetrachloroperylen-3,4:9,10-tetracarbonsäurediimid wurde als Produktgemisch mit dem entsprechenden trichlorierten Perylen, als orangefarbener Feststoff, in einer Menge von 12,83 g erhalten (Ausbeute 81 %). R_{f} (Toluol) = 0,39.

### 6.b) Herstellung von Octachlor-N,N'-bis(1H,1H-perfluorobutyl)-perylen-3,4:9,10-tetracarbonsäurediimid

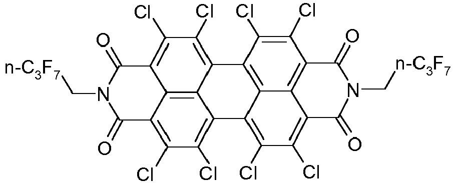

Das unter 6.a) erhaltenen Produktgemisch (19,0 g, 21 mmol) in Chlorsulfonsäure (200 g) wurde mit Iod (1,0 g) versetzt und erhitzt. Bei einer Temperatur von 60 °C wurde bei Normaldruck über einen Zeitraum von 7 Stunden ein Überschuss an Chlor in das Reaktionsgemisch eingeleitet. Über diesen Zeitraum wurde erneut Iod (1,0 g) portionsweise zugesetzt. Nach Abkühlen auf Raumtemperatur wurde das Reaktionsgemisch auf Eis gegeben. Der dabei ausfallende Feststoff wurde abfiltriert und mit Wasser gewaschen. Man erhielt 21,8 g (quant. Ausbeute) eines in Toluol löslichen, orangefarbenen Feststoffes (Chlorgehalt: 28,3 % (theor.: 27,5 %)).

### Beispiel 7: Herstellung von Tetrachlor-tetrafluor-N,N-dimethylperylen3,4:9,10-tetracarbonsäurediimid (nicht erfindungsgemäß)

Zu einer Mischung aus 150 ml ortho-Xylol, 0,75 g (3 mmol) (N,N'-Dimethylimidazolidino)-tetramethylguanidiniumchlorid und 14,0 g (240 mmol) Kaliumfluorid wurden 2,08 g (3 mmol) Octachlor-N,N'-dimethylperylen-3,4:;9,10-tetracarbonsäurediimid aus Beispiel 1.a gegeben und das Reaktionsgemisch wurde auf 80°C erwärmt. Bei dieser Temperatur wurde vier Stunden gerührt und anschließend auf Raumtemperatur abgekühlt. Das Reaktionsgemisch wurde direkt auf eine mit Kieselgel gefüllte Fritte gegeben und das Xylol wurde mit Petrolether ausgewaschen. Anschließend wurde das Produkt mit Methylenchlorid/ tert.-Butylmethylether 10:1 eluiert, wobei 0,62 g (53 %) eines bräunlichen Feststoffes erhalten wurden.

### Beispiel 8: Herstellung von Octafluor-N,N'-bis(1H,1H-perfluorbutyl)-perylen-3,4:9,10-tetracarbonsäurediimid

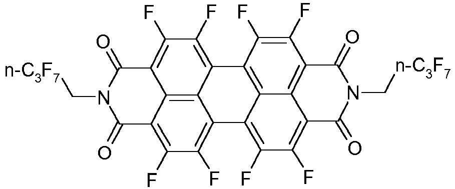

Zu einer Mischung aus 70 ml trockenem Xylol, 1,06 g (4 mmol) 18-Krone-6 und 4,65 g (80 mmol) Kaliumfluorid wurden 0,515 g (0,5 mmol) Octachlor-N,N'-bis(1H,1H-perfluorbutyl)-perylen-3,4:9,10-tetracarbonsäurediimid (Verbindung aus Beispiel 6.b) bei 40°C gegeben. Nach 1,5 stündigem Rühren bei dieser Temperatur wurde das Gemisch auf 80°C erhitzt, 30 Minuten bei dieser Temperatur gerührt, anschließend auf 120°C erhitzt und 30 Minuten bei dieser Temperatur gerührt, bevor auf Rückflusstemperatur erhitzt wurde. Das Reaktionsgemisch wurde zwei Stunden unter Rückfluss erhitzt. Danach wurde das Reaktionsgemisch abgekühlt, filtriert und der Rückstand mit Toluol gewaschen und das Filtrat eingeengt. Man reinigte das Produkt durch Chromatographie mit Dichlormethan auf, wobei man 79 mg (18%) eines bräunlichen Pulvers erhielt. R_{f} (Dichlormethan)= 0,28;
MALDI-MS: M- = 897,898:

### Beispiel 9: Herstellung von Tetrachlor-tetrafluor-N,N'-bis(1H,1H-perfluorbutyl)-perylen-3,4:9,10-tetracarbonsäurediimid (nicht erfindungsgemäß)

Zu einer Mischung von 100 ml wasserfreiem Xylol, 0,25 g (1 mmol) (N,N'-Dimethylimidazolidino)-tetramethylguanidiniumchlorid und 4,65 g (80 mmol) Kaliumfluorid wurden 1,03 g Octafluor-N,N-dimethylperylen-3,4;9,10-tetracarbonsäurediimid (Verbindung aus Beispiel 6.b) gegeben. Das Reaktionsgemisch wurde auf 120°C erhitzt und 30 Minuten bei dieser Temperatur gehalten. Nach Abkühlen auf Raumtemperatur wurde Kaliumfluorid abfiltriert und mit Dichlormethan und Petrolether gewaschen. Die erhaltene Lösung wurde durch Chromatographie an Kieselgel unter Verwendung von Petrolether und tert-Butylmethylether gereinigt.
R_{f} (CH₂Cl₂) = 0,49;
MALDI-MS: M- = 961,8 g/mol.

### Beispiel 10: Herstellung von Octafluor-N,N'-(2,6-diisopropylphenyl)-perylen-3,4:9,10-tetracarbonsäurediimid

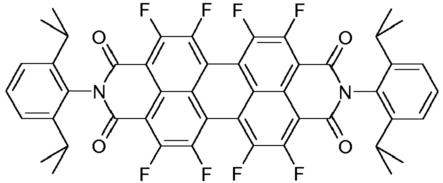

Zu einer Mischung aus 35 ml o-Xylol, 0,25 g (1 mmol) (N,N'-Dimethylimidazolidino)-tetramethylguanidiniumchlorid und 4,5 g (80 mmol) Kaliumfluorid gab man 1,0 g (1,02 mmol) Octachlor-N,N'-bis(2,6-diisopropylphenyl)-perylen-3,4:9,10-tetracarbonsäurediimid (Verbindung aus Beispiel 5). Das Reaktionsgemisch wurde eine Stunde am Rückfluss erhitzt, anschließend abgekühlt und durch Chromatographie an Toluol gereinigt.
R_{f} (Toluol: Essigester 10:1) = 0,6.

### Beispiel 11: Herstellung von N,N'-Bis(3,5-trifluormethylphenyl)-perchlorperylen-3,4:9,10-tetracarbonsäurediimid

### 11.a: Herstellung von N,N'-Bis(3,5-trifluormethylphenyl)-1,6,7,12-tetrachlorperylen-3,4:9,10-tetracarbonsäurediimid (nicht erfindungsgemäß)

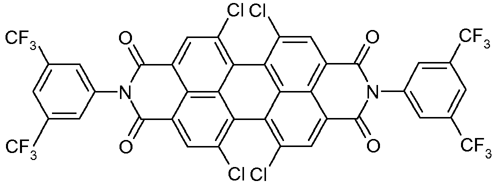

Eine Mischung aus 10,6 g (20 mmol) 1,6,7,12-Tetrachlorperylen-3,4:9,10-tetracarbonsäuredianhydrid, 100 ml NMP, 12,8 g (56 mmol) 3,5-Bistrifluormethylanilin und 7,2 g (120 mmol) Essigsäure wurden ca. 70 Stunden auf 90°C erhitzt. Man ließ das Reaktionsgemisch abkühlen und goss danach auf 1000 ml verdünnte Salzsäure, filtrierte den Niederschlag ab, wusch mit Wasser und trocknete im Vakuum. Das Produkt wurde durch Chromatographie an Kieselgel unter Verwendung eines Gemischs aus Toluol und Petrolether unter Anwendung eines Konzentrationsgradients aufgereinigt. Man erhielt 8,52 g (45%) eines orangefarbenen Pulvers.
R_{f}(Toluol: Dichlormethan 1:1) = 0,67

### 11.b: Herstellung von N,N'-Bis(3,5-trifluormethylphenyl)-perchlorperylen-3,4:9,10-tetracarbonsäurediimid

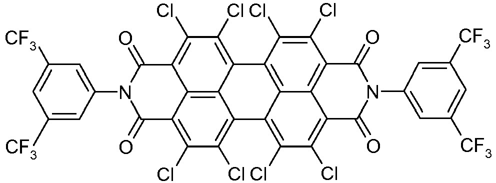

Eine Mischung aus 7,9 g der Verbindung aus 11.a, 95,0 g (55 ml) Chlorsulfonsäure unnd 0,5 g Iod wurde auf 60°C erhitzt. Man leitete 53,0 g Chlor unter die Oberfläche der Mischung ein und rührte 3 Stunden bei 60°C und 48 Stunden bei Raumtemperatur. Der Ansatz wurde auf Eis gegeben, filtriert und mit Wasser neutral gewaschen. Man erhielt 7,3 g eines orangefarbenen Rohproduktes. 3,0 g des Rohproduktes wurden durch Säulenchromatographie (Säule mit einem Durchmesser von 6,5 cm) an 180 g Kieselgel unter Verwendung von Petrolether / Dichlormethan 1,5 : 1 aufgereinigt. Man erhielt 0,93 g reine Titelverbindung. R_{f}(Toluol) = 0.61

### Beispiel 12: Herstellung von N,N'-Bis(1,H, 1'H, 2H, 2'H-perfluordecyl)-octachlorperylen-3,4:9,10-tetracarbonsäurediimid

### 12.a: Herstellung von N,N'-Bis(1,H,1'H, 2H,2'H-perfluordecyl)-1,6,7,12-tetrachlorperylen-3,4:9,10-tetracarbonsäurediimid (nicht erfindungsgemäß)

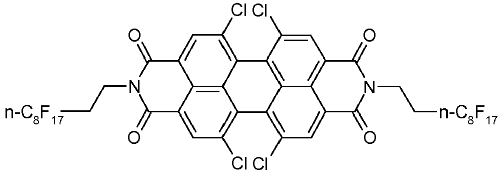

Die Verbindung wurde analog zu dem Verfahren in Beispiel 6.a hergestellt.

### 12.b: Herstellung von N,N'-Bis(1,H, 1'H, 2H, 2'H-perfluordecyl)-octachlorperylen-3,4:9,10-tetracarbonsäurediimid

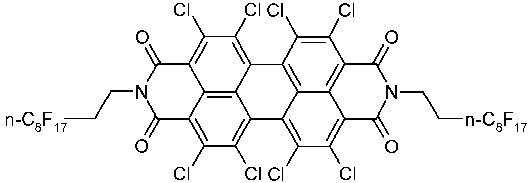

Die Chlorierung erfolgte analog zu Beispiel 11.b, abgesehen davon, dass insgesamt in vier Portionen 212 g Chlor über einen Zeitraum von vier Tagen bei 60°C eingeleitet wurden. Das Reaktionsgemisch wurde auf Eiswasser gegeben, filtriert, mit Wasser neutral gewaschen und im Vakuum getrocknet. 6,.0 g eines orangefarbenen Rohproduktes wurden durch Säulenchromatographie (Säule mit einem Durchmesser von 6,5 cm) an 180 g Kieselgel mit Toluol / Petrolether 1:1 aufgereinigt. Es wurden 3,8 g reine Titelverbindung erhalten. R_{f} (Toluol) = 0,72.

Die Verbindungen der Beispiele 13 und 14 wurden in analoger Weise hergestellt.

### Beispiel 13: Herstellung von Octachlor-N,N'-bis(1H,1H-perfluoroctyl)-perylen-3,4:9,10-tetracarbonsäurediimid

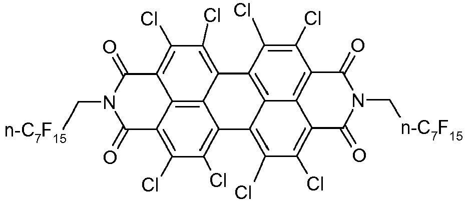

### Beispiel 14: Herstellung von Octafluor-N,N'-bis(1H,1H-perfluoroctyl)-perylen-3,4:9,10-tetracarbonsäurediimid

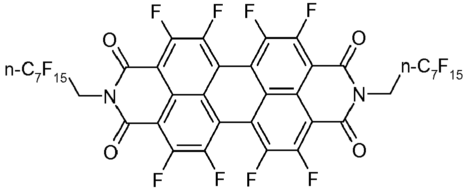

Allgemeine Vorschrift zur Ermittlung der Feldeffekttransistorkenndaten

### 1. Herstellung von Halbleitersubstraten mittels physical vapor deposition (PVD)

Als Substrate wurden hochdotierte n-Typ (100 nm) Siliciumwafer (Leitfähigkeit < 0,004 Ω⁻¹cm) mit thermisch abgeschiedener Oxidschicht (300 nm) als Gate-Dielektrikum (flä-chenbezogene Kapazität Cᵢ = 10 nF/cm²) eingesetzt. Die beschichteten Substrate wurden durch Spülen mit Aceton und Isopropanol gereinigt. Die Halbleiterverbindungen wurden im Vakuum bei definierten Abscheidungstemperaturen zwischen 25 und 150 °C (typischerweise bei 125 °C) aufgedampft und mit einer Abscheidungsrate im Bereich von 0,3 bis 0,5 Å/s und einem Druck von 10⁻⁶ Torr in einer Vakuumbeschichtungsvorrichtung (Angstrom Engineering Inc., Kanada) auf dem Substrat abgeschieden. Zur Messung der Ladungsmobilitäten des erhaltenen Materials wurden TFT in Top-Kontakt-Konfiguration bereitgestellt. Dazu wurden Source- und Drain-Elektroden aus Gold (typischerweise von 100 µm Kanallänge und einem Längen/Breitenverhältnis von etwa 20) mittels Gasphasenabscheidung durch eine Lochmaske abgeschieden. Die elektrischen Eigenschaften der TFTs wurden mittels Keithley 4200-SCS Halbleiter-Parameter-Analysator ermittelt.

### 2. Oberflächenbehandlung

### a) OTS-V

Nach dem Reinigen der mit SiO₂ beschichteten Wafer durch Spülen mit Aceton und Isopropanol kann die Oberfläche zusätzlich z.B. mit n-Octadecyltriethoxysilan (OTS, C₁₈H₃₇Si(OC₂H₅)₃) modifiziert werden. Dazu gab man einige Tropfen OTS (Aldrich Chem. Co.) auf die vorgeheizte Oberfläche (etwa 100 °C) in einem Vakuumexsiccator. Der Exsiccator wurde evakuiert und die Substrate wurden wenigstens 5 Stunden unter Vakuum gehalten (25 mm Hg). Abschließend wurden die Substrate 15 Minuten bei 110 °C gebacken, mit Isopropanol gespült und im Stickstoffstrom getrocknet.

### b) unmodifizierte Oberfläche

Die SiO₂/Si-Substrate wurden mit Toluol, Aceton und Isopropanol gespült und im Stickstoffstrom getrocknet. Die gereinigten Wafer wurden ohne weitere Oberflächenmodifikation eingesetzt.

### 3. Reinigung

Die Reinigung der Verbindungen erfolgt durch Dreizonengradientensublimation.

### Beispiel 15: Feldeffektransistor mit der Verbindung aus Beispiel 2

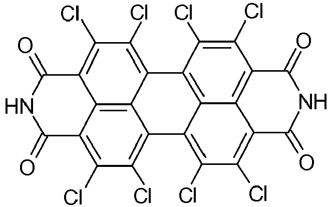

Die Verbindung wurde bei 125°C abgeschieden. Das Bauteil wurde sowohl unter Stickstoff als auch in Luftatmosphäre vermessen. Die Ergebnisse sind in Tabelle 1 aufgelistet.

**Tabelle 1:**

| Oberflächenbehandlung | | N₂ | Luft*) |
|---|---|---|---|
| mit OTS-V | Mobilität µ (cm²/Vs) | 0,27 | 0,20 |
| | Iₒₙ/I_{off} | 1,4 x 10⁵ | 1,5 x 107 |
| | Vₜ (V) | 22,0 | 30,2 |
| ohne Oberflächenbehandlung | Mobilität µ (cm²/Vs) | 2,9 x 10⁻⁵ | n.b |
| | Iₒₙ/I_{off} | 1,3 x 10³ | n.b |
| | Vₜ (V) | 16,2 | n.b |

| | | | |
|---|---|---|---|
| * relative Luftfeuchtigkeit: etwa 42 % n.b. nicht bestimmt | | | |

### Beispiel 16: Feldeffekttransistor mit der Verbindung aus Beispiel 6.b

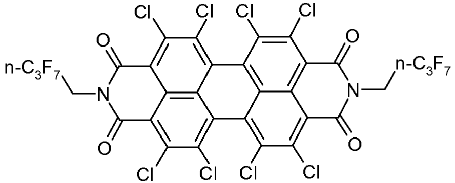

Die Verbindung wurde bei 125°C abgeschieden. Das Bauteil wurde sowohl unter Stickstoff als auch in Luftatmosphäre vermessen. Die Ergebnisse sind in Tabelle 2 aufgelistet.

**Tabelle 2:**

| Oberflächenbehandlung | | N₂ | Luft*) |
|---|---|---|---|
| mit OTS-V | Mobilität µ (cm²/Vs) | 0,060 | 0,044 |
| | Iₒₙ/I_{off} | 20,3 | 28,4 |
| | Vₜ (V) | 1,2 x 10³ | 1,8 x 10³ |
| ohne Oberflächenbehandlung | Mobilität µ (cm²/Vs) | 2,0 x 10⁻⁵ | n.b. |
| | Iₒₙ/I_{off} | 7,2 x 10² | n.b |
| | Vₜ (V) | 17,9 | n.b |

| | | | |
|---|---|---|---|
| * relative Luftfeuchtigkeit: etwa 42 % n.b. nicht bestimmt | | | |

### Beispiel 17: Feldeffekttransistor mit der Verbindung aus Beispiel 3

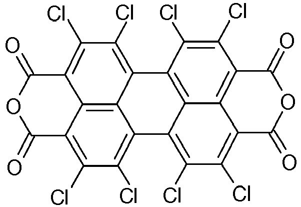

Die Verbindung wurde bei 125°C abgeschieden. Das Bauteil wurde sowohl unter Stickstoff als auch in Luftatmosphäre vermessen. Die Ergebnisse sind in Tabelle 3 aufgelistet.

**Tabelle 3:**

| Oberflächenbehandlung | | N₂ | Luft*) |
|---|---|---|---|
| mit OTS-V | Mobilität µ (cm²/Vs) | 1,1 x 10⁻⁵ | 3,9 x 10⁻⁶ |
| | Iₒₙ/I_{off} | 3,9 x 10² | 1,4 x 10³ |
| | Vₜ (V) | 26,6 | 34,9 |

| | | | |
|---|---|---|---|
| * relative Luftfeuchtigkeit: etwa 42 % | | | |

## Patentansprüche

1. Verwendung von Verbindungen der allgemeinen Formeln (I.A), (I.Ba), (I.Bb1) oder (I.Bb2) 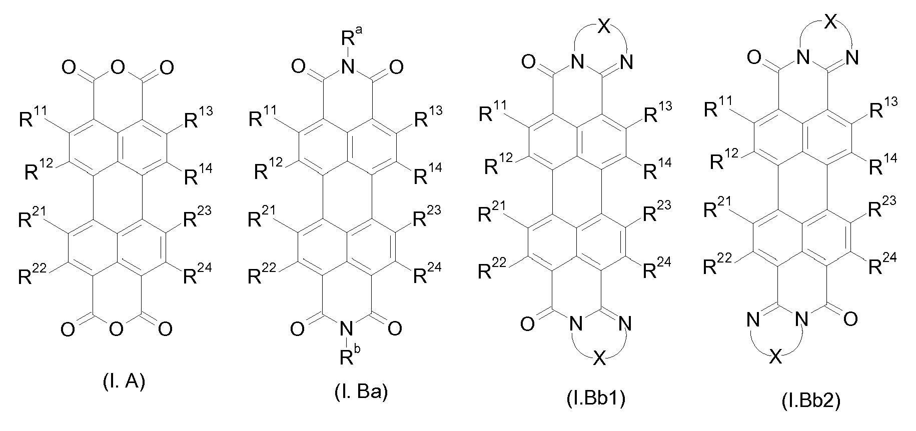 worin
die Reste R¹¹, R¹², R¹³, R¹⁴, R²¹, R²², R²³ und R²⁴ alle für Chlor oder alle für Fluor stehen;
R^{a} und R^{b} in der Verbindung der Formel (I.Ba) unabhängig voneinander für Wasserstoff, 2,2,2-Trifluorethyl, 2,2,3,3,3-Pentafluorpropyl, 2,2-Difluorethyl, 2,2,3,3,4,4,4-Heptafluorbutyl, 1H,1H-Pentadecafluoroctyl, 3-Brom-3,3-difluorpropyl, 3,3,3-Trifluorpropyl, 1H,1H,2H,2H-Perfluordecyl, 3-(Perfluoroctyl)propyl, 4,4-Difluorbutyl, 4,4,4-Trifluorbutyl, 5,5,6,6,6-Pentafluorhexyl, 2,2-Difluorpropyl, oder unsubstituiertes oder substituiertes Cycloalkyl, Aryl oder Heteroaryl stehen;
X in den Verbindungen der Formeln (I.Bb1) und (I.Bb2) für eine zweiwertige verbrückende Gruppe mit 2 bis 5 Atomen zwischen den flankierenden Bindungen steht;
als Emittermaterialien, Ladungstransportmaterialien oder Excitonentransportmaterialien.

2. Verwendung nach Anspruch 1, wobei in den Verbindungen der Formeln (I.Bb1) und (I.Bb2) die verbrückende Gruppe X ausgewählt ist unter Gruppen der Formeln (IIIa) bis (III.d) 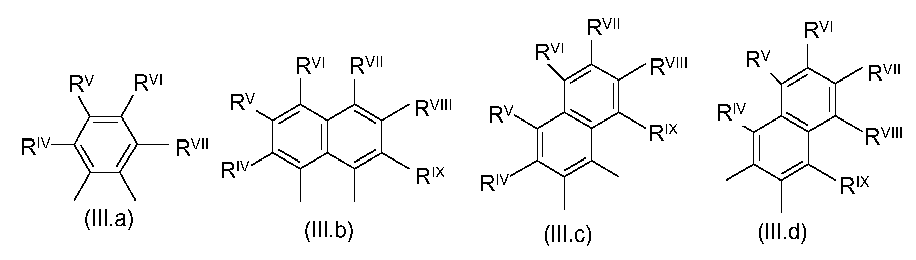 worin
R^{IV}, R^{V}, R^{V}, R^{VII}, R^{VIII} und R^{IX} unabhängig voneinander für Wasserstoff, Alkyl, Alkoxy, Cycloalkyl, Cycloalkoxy, Heterocycloalkyl, Heterocycloalkoxy, Aryl, Aryloxy, Hetaryl, Hetaryloxy, Halogen, Hydroxy, Mercapto, COOH, Carboxylat, SO₃H, Sulfonat, NE¹E², Alkylen-NE¹E², Nitro, Alkoxycarbonyl, Acyl oder Cyano stehen, wobei E¹ und E² unabhängig voneinander für Wasserstoff, Alkyl, Cycloalkyl, Heterocycloalkyl, Aryl oder Hetaryl stehen,
wobei der Ausdruck Hetaryl unsubstituierte oder substituierte, heteroaromatische, ein- oder mehrkernige Gruppen umfasst.

3. Verwendung nach Anspruch 2, wobei R^{IV}, R^{V}, R^{VI}, R^{VII}, R^{VIII} und R^{IX} jeweils für Wasserstoff stehen.

4. Verwendung nach Anspruch 1 der folgenden Verbindungen:

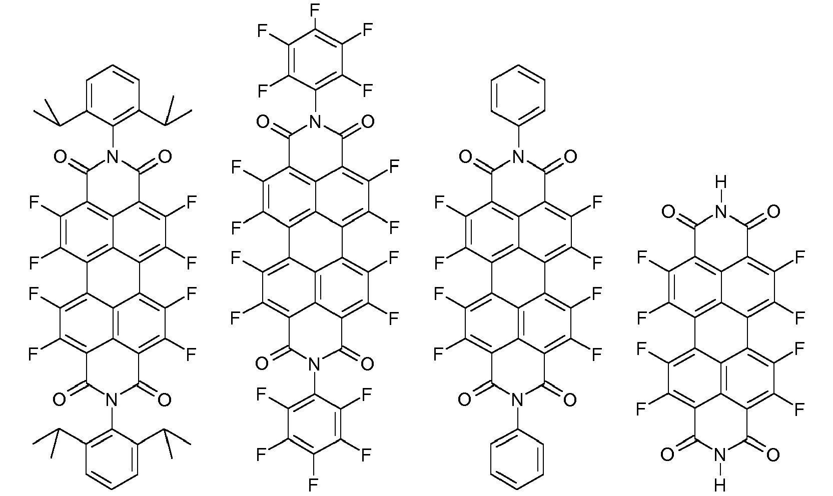

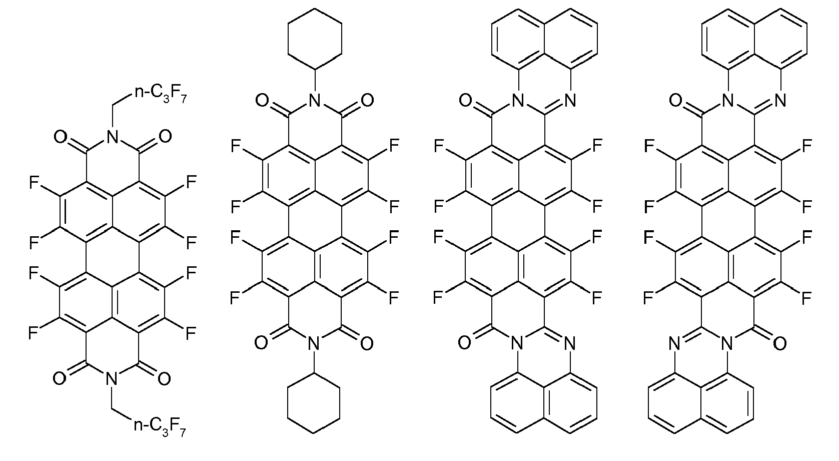

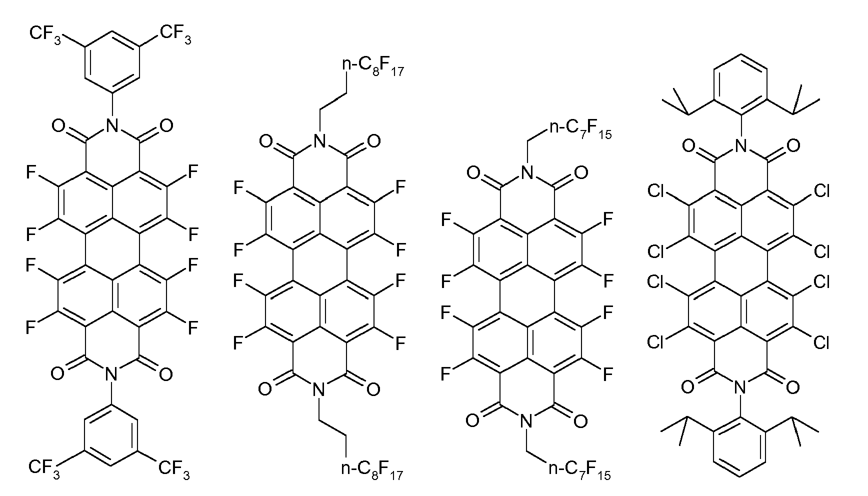

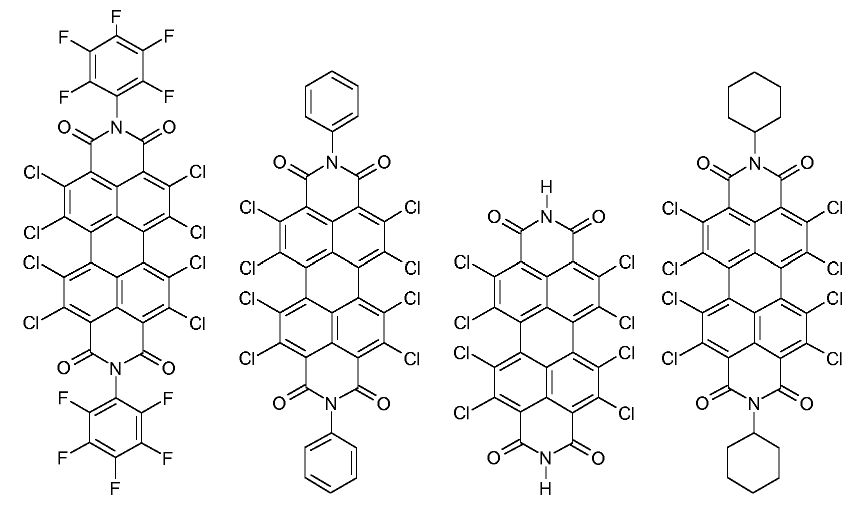

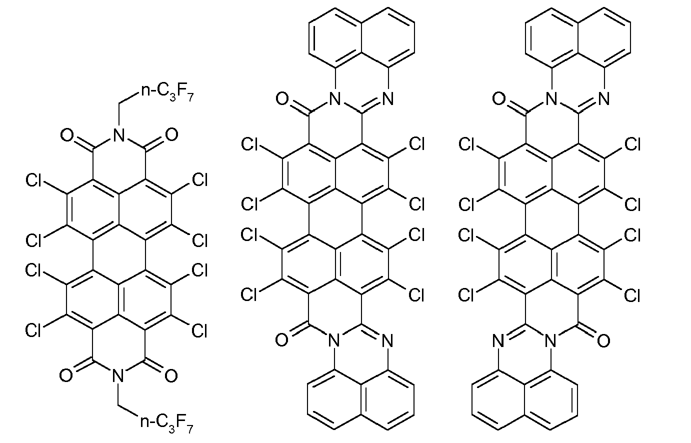

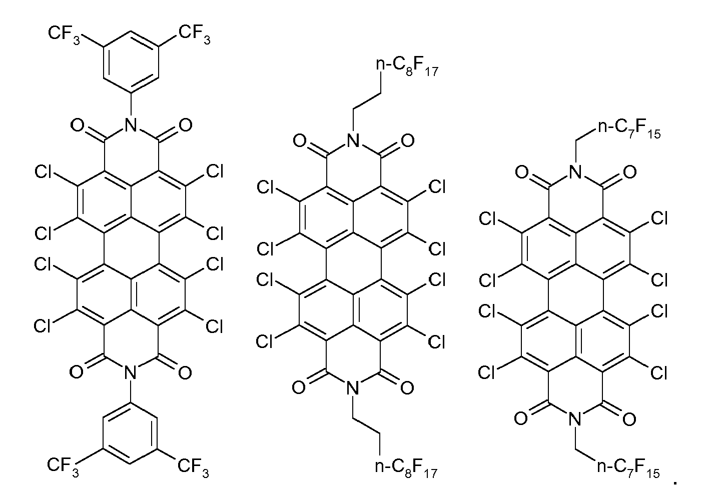

5. Verwendung von Verbindungen der allgemeinen Formeln (I.A), (I.Ba), (I.Bb1) oder (I.Bb2) wie in einem der Ansprüche 1 bis 4 definiert, als Elektronenleiter in organischen Feldeffekttransistoren, organischen Solarzellen und in organischen Leuchtdioden.

6. Verwendung nach Anspruch 5 als Halbleitermaterial in organischen Feldeffekttransistoren.

7. Verwendung von Verbindungen der allgemeinen Formeln (I.A), (I.Ba), (I.Bb1) oder (I.Bb2) wie in einem der Ansprüche 1 bis 4 definiert, als aktives Material in der organischen Photovoltaik, insbesondere als Excitonentransportmaterial in excitonischen Solarzellen.

8. Verwendung einer Verbindung der allgemeinen Formeln (I.A), (I.Ba), (I.Bb1) oder (I.Bb2) wie in einem der Ansprüche 1 bis 4 definiert, für optische Label, zur unsichtbaren Markierung von Produkten, als Fluoreszenzfarbstoffe, als Fluoreszenzlabel für Biomoleküle und als Pigmente.

9. Verwendung einer Verbindung der allgemeinen Formeln (I.A), (I.Ba), (I.Bb1) oder (I.Bb2) wie in einem der Ansprüche 1 bis 4 definiert, als Fluoreszenzfarbstoff in einem auf Fluoreszenzkonversion beruhenden Display; in einem lichtsammelnden Kunststoffteil, welches gegebenenfalls mit einer Solarzelle kombiniert ist; als Pigmentfarbstoff in elektrophoretischen Displays; als Fluoreszenzfarbstoff in einer auf Chemolumineszenz basierenden Anwendung.

10. Verbindungen der Formel (I.A), 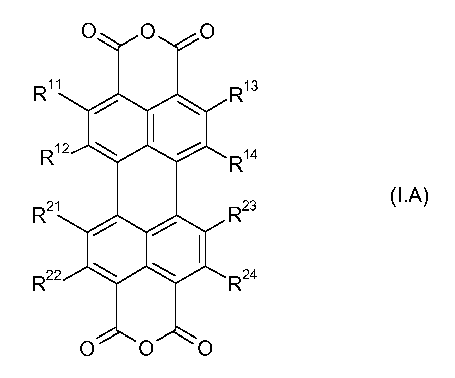 worin R¹¹, R¹², R¹³, R¹⁴, R²¹, R²², R²³ und R²⁴ alle für Fluor stehen.

11. Verbindungen der Formel (I.Ba) 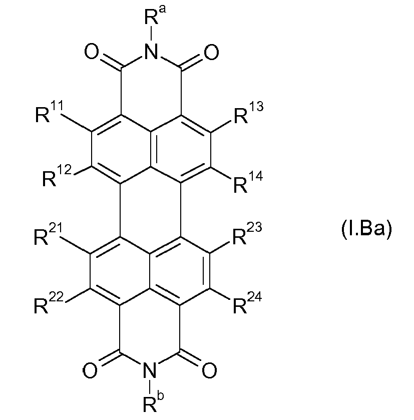 worin R^{a}, R^{b}, R¹¹, R¹², R¹³, R¹⁴, R²¹, R²², R²³ und R²⁴ eine der in Anspruch 1 gegebenen Bedeutungen aufweisen.

12. Verbindungen der Formeln (I.Bb1) und (I.Bb2) 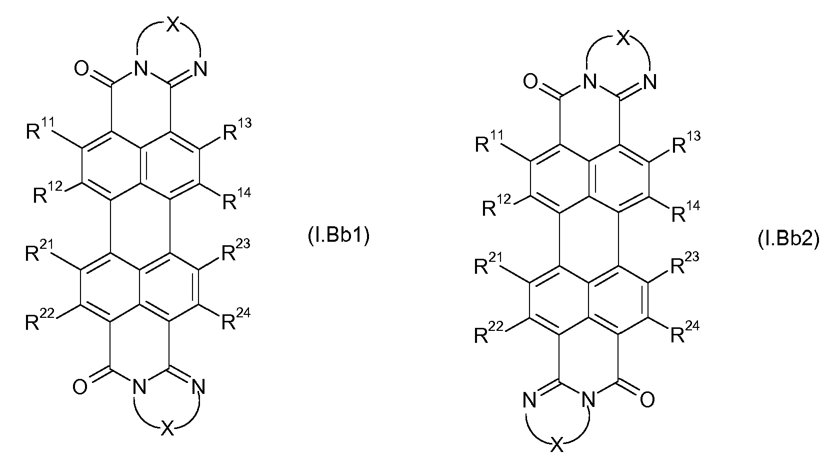 worin R¹¹, R¹², R¹³, R¹⁴, R²¹, R²², R²³, R²⁴ und X eine der in Anspruch 1 gegebenen Bedeutungen aufweisen.

13. Organischer Feldeffekttransistor, umfassend ein Substrat mit wenigstens einer Gate-Struktur, einer Source-Elektrode und einer Drain-Elektrode und wenigstens eine Verbindung der Formel (I.A), (I.Ba), (I.Bb1) oder (I.Bb2) wie in einem der Ansprüche 1 bis 4 definiert, als n-Halbleiter.

14. Organische Solarzelle umfassend wenigstens eine Verbindung der Formeln (I.A), (I.Ba), (I.Bb1) oder (I.Bb2) wie in einem der Ansprüche 1 bis 4 definiert.

15. OLED umfassend wenigstens eine Verbindung der Formeln (I.A), (I.Ba), (I.Bb1) oder (I.Bb2) wie in einem der Ansprüche 1 bis 4 definiert.

16. Substrat mit einer Vielzahl von organischen Feldeffekttransistoren, wobei zumindest ein Teil der Feldeffekttransistoren wenigstens eine Verbindung der Formel (I.A), (I.Ba), (I.Bb1) oder (I.Bb2) wie in einem der Ansprüche 1 bis 4 definiert, als n-Halbleiter enthält.

## Claims

1. The use of compounds of the general formulae (I.A), (I.Ba), (I.Bb1) or (I.Bb2) 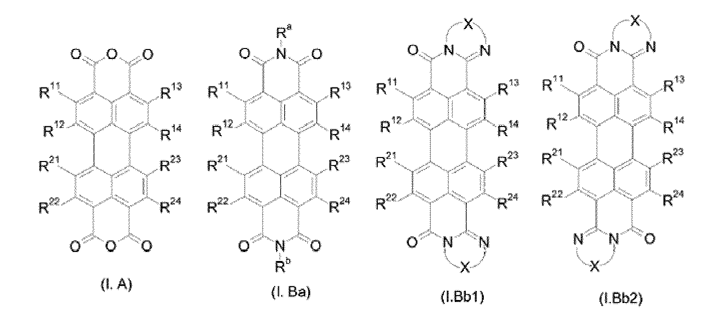 in which
the R¹¹, R¹², R¹³, R¹⁴, R²¹, R²², R²³ and R²⁴ radicals are all chlorine or are all fluorine;
R^{a} and R^{b} in the compound of the formula (I.Ba) are each independently hydrogen, 2,2,2-trifluoroethyl, 2,2,3,3,3-pentafluoropropyl, 2,2-difluoroethyl, 2,2,3,3,4,4,4-heptafluorobutyl, 1H,1H-pentadecafluorooctyl, 3- bromo-3,3-difluoropropyl, 3,3,3-trifluoropropyl, 1H,1H,2H,2H-perfluorodecyl, 3-(perfluorooctyl)propyl, 4,4-difluorobutyl, 4,4,4-trifluorobutyl, 5,5,6,6,6-pentafluorohexyl, 2,2-difluoropropyl, or unsubstituted or substituted cycloalkyl, aryl or heteroaryl;
in the compounds of the formulae (I.Bb1) and (I.Bb2) is a divalent bridging group having from 2 to 5 atoms between the flanking bonds;
as emitter materials, charge transport materials or exciton transport materials.

2. The use according to claim 1, wherein in the compounds of the formulae (I.Bb1) and (I.Bb2) the bridging X group is selected from groups of the formulae (III.a) to (III.d) 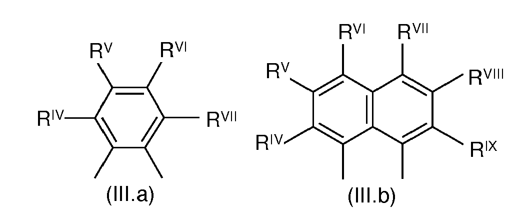 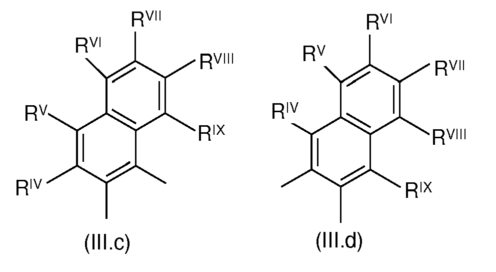 in which
R^{IV}, R^{V}, R^{V}, R^{VII}, R^{VIII} and R^{IX} are each independently hydrogen, alkyl, alkoxy, cycloalkyl, cycloalkoxy, heterocycloalkyl, heterocycloalkoxy, aryl, aryloxy, hetaryl, hetaryloxy, halogen, hydroxyl, mercapto, COOH, carboxylate, SO₃H, sulfonate, NE¹E², alkylene-NE¹E², nitro, alkoxycarbonyl, acyl or cyano, where E¹ and E² are each independently hydrogen, alkyl, cycloalkyl, heterocycloalkyl, aryl or hetaryl, where the expression hetaryl comprises unsubstituted or substituted, heteroaromatic, mono- or polycylic groups.

3. The use according to claim 2, wherein R^{IV}, R^{V}, R^{VI}, R^{VII}, R^{VIII}, and R^{IX} are each hydrogen.

4. The use according to claim 1 of the following compounds:

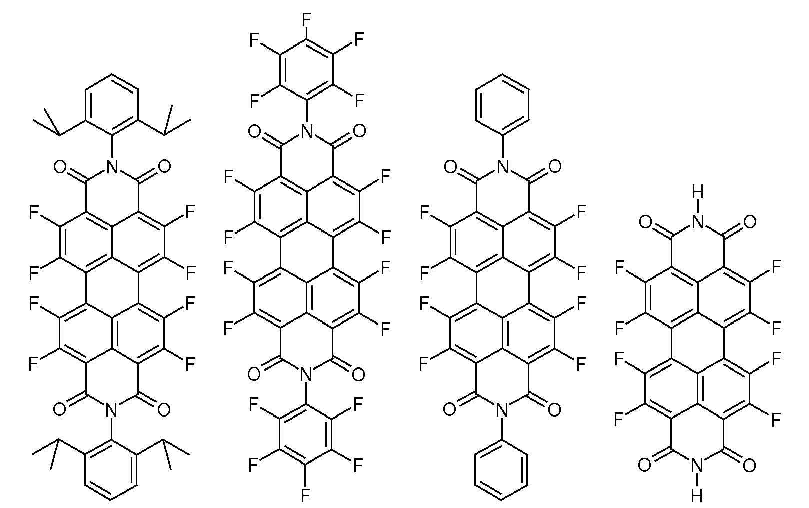

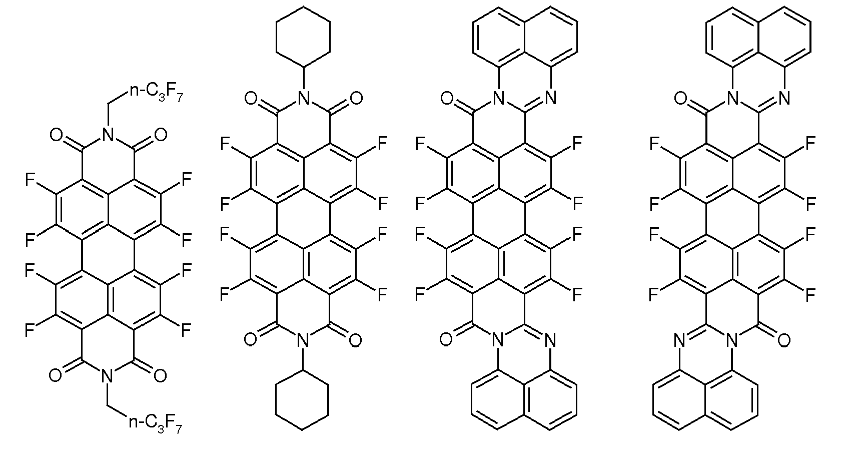

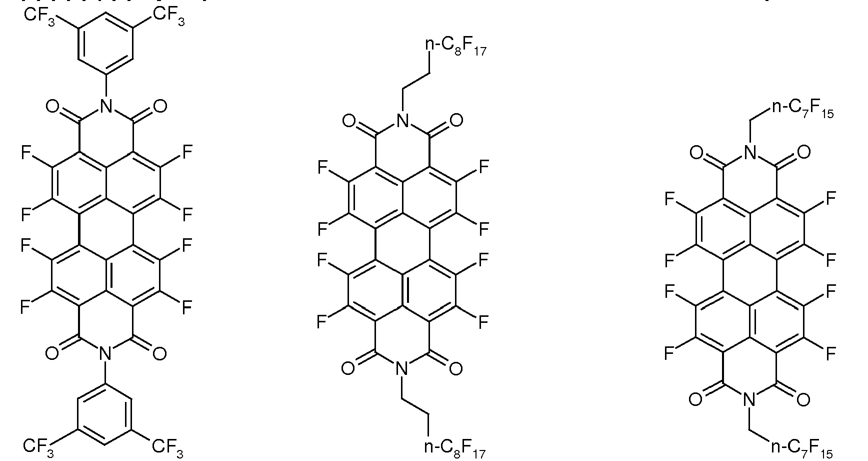

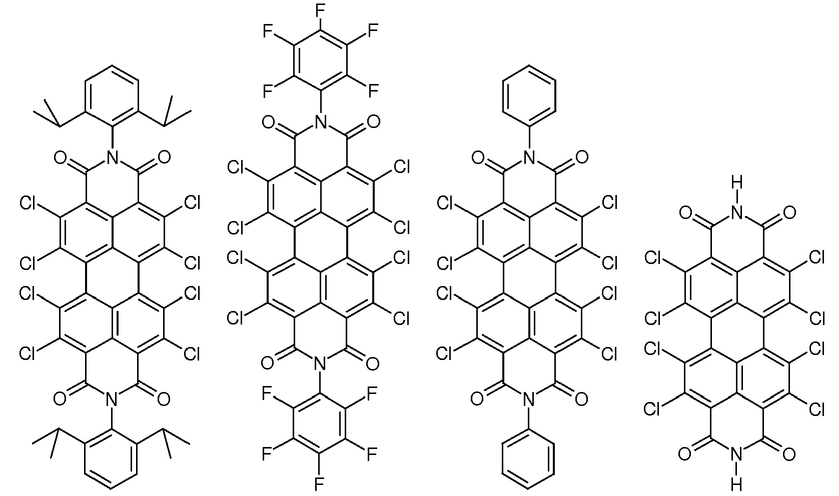

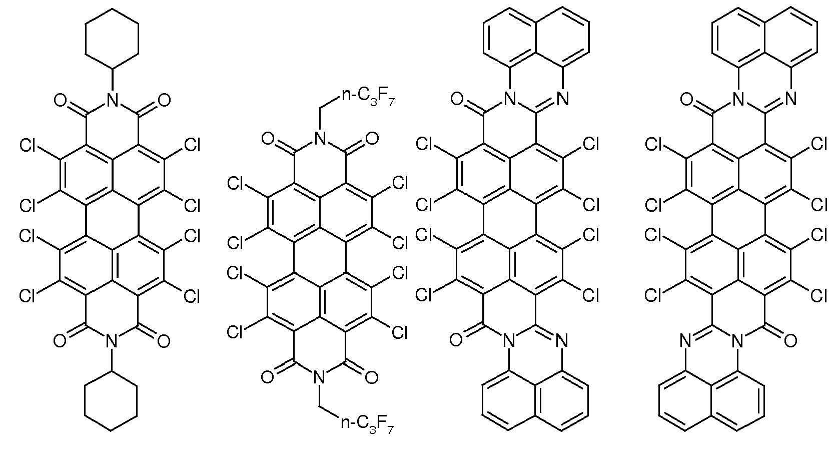

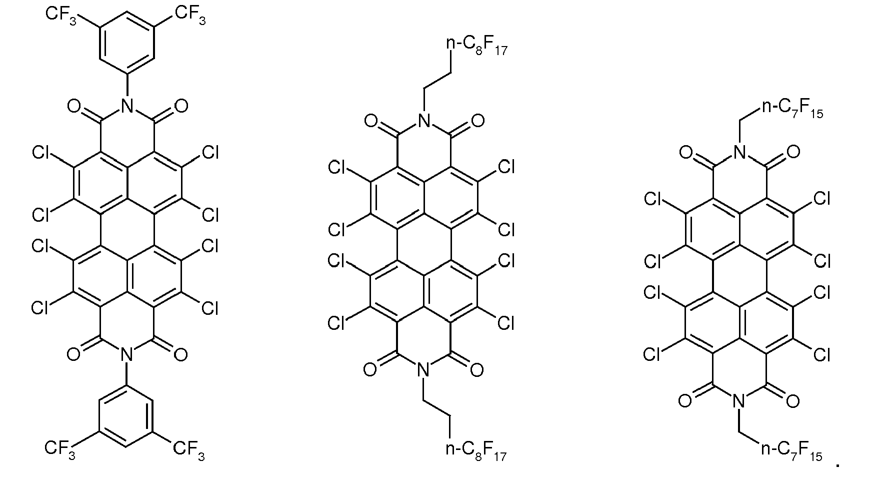

5. The use of compounds of the general formulae (I.A), (I.Ba), (I.Bb1) or (I.Bb2) as defined in any of claims 1 to 4 as electron conductors in organic field-effect transistors, organic solar cells and in organic light-emitting diodes.

6. The use according to claim 5 as semiconductor material in organic field-effect transistors.

7. The use of compounds of the general formulae (I.A), (I.Ba), (I.Bb1) or (I.Bb2) as defined in any of claims 1 to 4 as active material in organic photovoltaics, especially as exciton transport material in excitonic solar cells.

8. The use of a compound of the general formulae (I.A), (I.Ba), (I.Bb1) or (I.Bb2) as defined in any of claims 1 to 4 for optical labels, for invisible marking of products, as fluorescent dyes, as fluorescent labels for biomolecules and as pigments.

9. The use of a compound of the general formulae (I.A), (I.Ba), (I.Bb1) or (I.Bb2) as defined in any of claims 1 to 4 as a fluorescent dye in a display based on fluorescence conversion; in a light-collecting plastics part which is optionally combined with a solar cell; as a pigment dye in electrophoretic displays; as a fluorescent dye in an application based on chemoluminescence.

10. A compound of the formula (I.A) 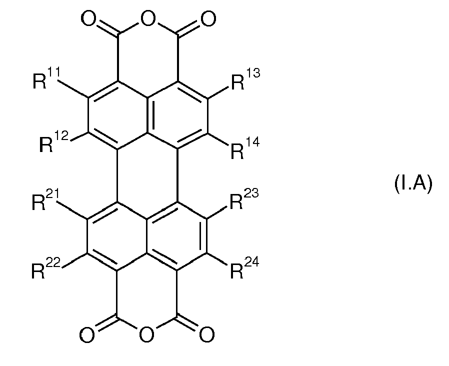 in which R¹¹, R¹², R¹³, R¹⁴, R²¹, R²², R²³ and R²⁴ are all fluorine.

11. A compound of the formula (I.Ba) 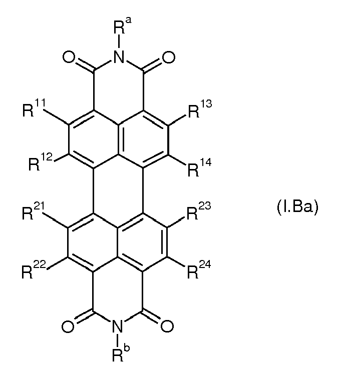 in which R³ R^{b}, R¹¹, R¹², R¹³, R¹⁴, R²¹, R²², R²³ and R²⁴ each have one of the definitions given in claim 1.

12. A compound of the formula (I.Bb1) or (I.Bb2) 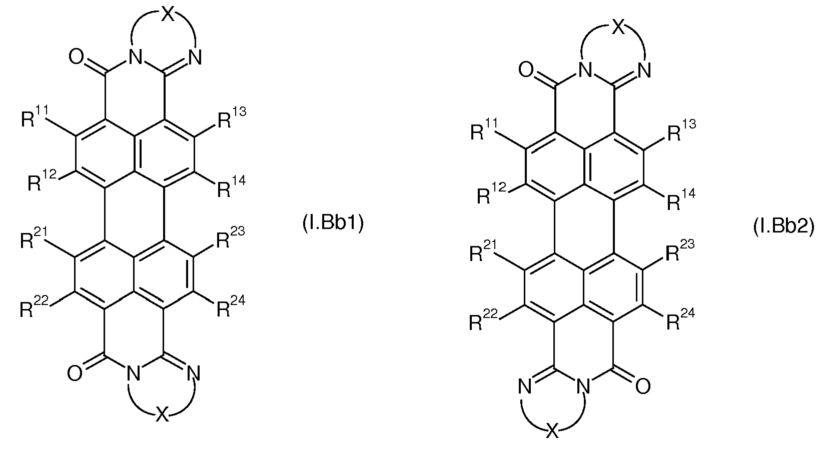 in which R¹¹, R¹², R¹³, R¹⁴, R²¹, R²², R²³, R²⁴ and X each have one of the definitions given in claim 1.

13. An organic field-effect transistor comprising a substrate having at least one gate structure, a source electrode and a drain electrode, and at least one compound of the formulae (I.A), (I.Ba), (I.Bb1) or (I.Bb2) as defined in any of claims 1 to 4 as an n-semiconductor.

14. An organic solar cell comprising at least one compound of the formulae (I.A), (I.Ba), (I.Bb1) or (I.Bb2) as defined in any of claims 1 to 4.

15. An OLED comprising at least one compound of the formulae (I.A), (I.Ba), (I.Bb1) or (I.Bb2) as defined in any of claims 1 to 4.

16. A substrate having a multitude of organic field-effect transistors, wherein at least some of the field-effect transistors comprise at least one compound of the formulae (I.A), (I.Ba), (I.Bb1) or (I.Bb2) as defined in any of claims 1 to 4 as an n-semiconductor.

## Revendications

1. Utilisation de composés de formules générales (I.A), (I.Ba), (I.Bb1) ou (I.Bb2) 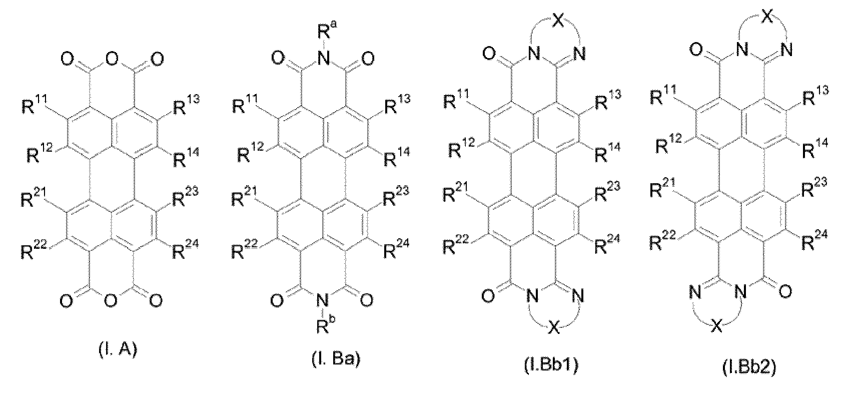 dans lesquelles
les radicaux _{R11}, R¹², R¹³, R¹⁴, R²¹, R²², R²³ et R²⁴ représentent tous des groupes chloro, ou tous des groupes fluoro,
R^{a} et R^{b}, dans le composé de formule (I.Ba), représentent chacun indépendamment de l'autre un atome d'hydrogène, le groupe 2,2,2-trifluoroéthyle, 2,2,3,3,3-pentafluoropropyle, 2,2-difluoroéthyle, 2,2,3,3,4,4,4-heptafluorobutyle, 1H,1H-pentadécafluoroctyle, 3-bromo-3,3-difluoropropyle, 3,3,3-trifluoropropyle, 1H,1H,2H,2H-perfluorodécyle, 3-(perfluoroctyl)propyle, 4,4-difluorobutyle, 4,4,4-trifluorobutyle, 5,5,6,6,6-pentafluorhexyle, 2,2-difluoropropyle ou cycloalkyle, aryle ou hétéroaryle non substitué ou substitué ;
X, dans les composés de les formules (I.Bb1) et (I.Bb2), représentent un groupe pontant divalent ayant 2 à 5 atomes entre les liaisons flanquantes ;
en tant que matériaux émetteurs, matériaux de transport de charge ou matériaux de transport d'excitons.

2. Utilisation selon la revendication 1, pour laquelle, dans les composés de formules (I.Bb1) et (I.Bb2), le groupe pontant X est choisi parmi les groupes ayant les formules (IIIa) à (III.d) 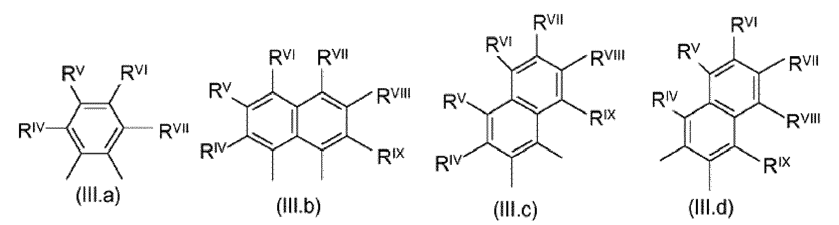 dans lesquelles
R^{IV}, R^{V}, R^{VI}, R^{VII}, R^{VIII} et R^{IX} représentent chacun indépendamment des autres un atome d'hydrogène, un groupe alkyle, alcoxy, cycloalkyle, cycloalcoxy, hétérocycloalkyle, hétérocycloalcoxy, aryle, aryloxy, hétéroaryle, hétéroaryloxy, halogéno, hydroxy, mercapto, COOH, carboxylate, SO₃H, sulfonate, NE¹E², alkylène-NE¹E², nitro, alcoxycarbonyle, acyle ou cyano, E¹ et E² représentant chacun indépendamment de l'autre un atome d'hydrogène, un groupe alkyle, cycloalkyle, hétérocycloalkyle, aryle ou hétéroaryle,
le terme hétéroaryle englobant les groupes mono ou polycycliques, hétéroaromatiques, non-substitués ou substitué.

3. Utilisation selon la revendication 2, pour laquelle R^{IV}, R^{V}, R^{VI}, R^{VII}, R^{VIII} et R^{IX} représentent chacun un atome d'hydrogène.

4. Utilisation selon la revendication 1 des composés suivants :

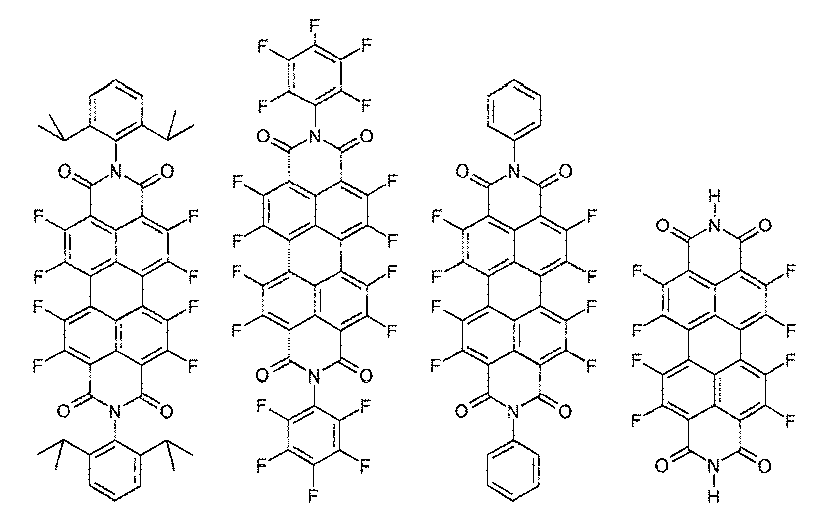

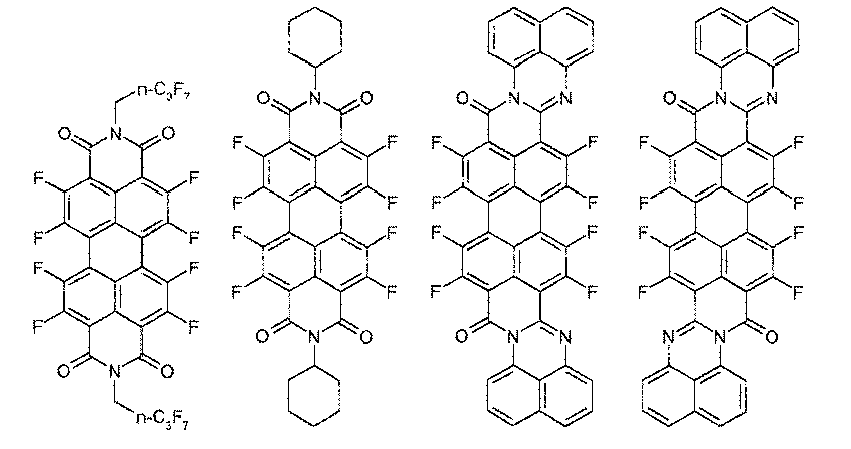

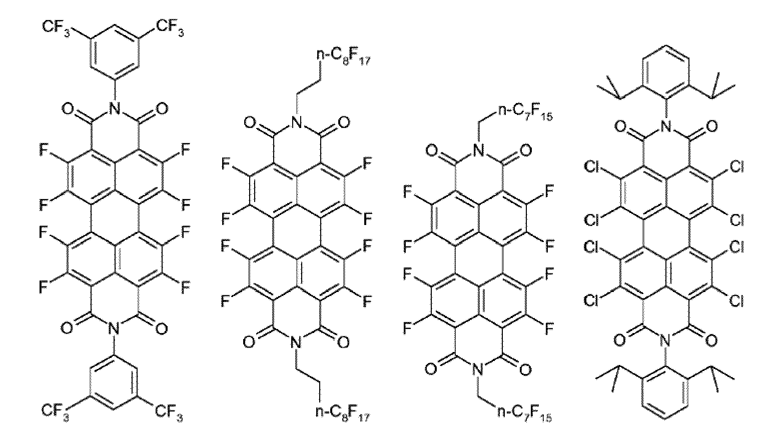

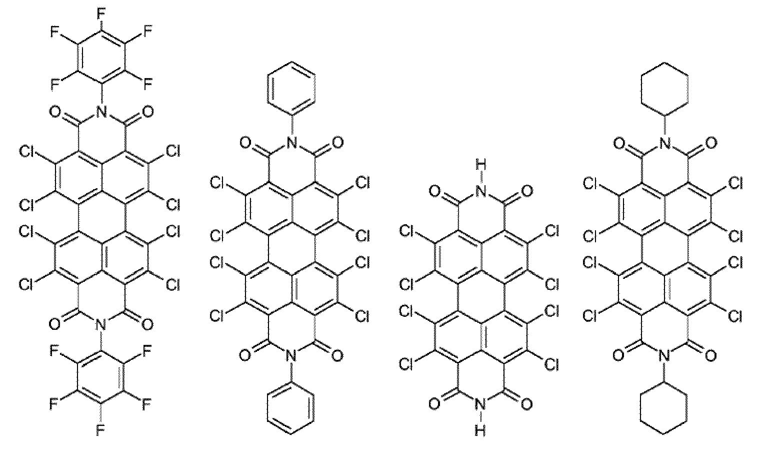

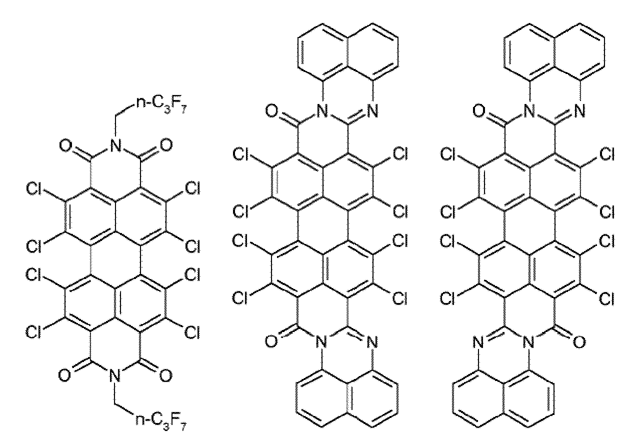

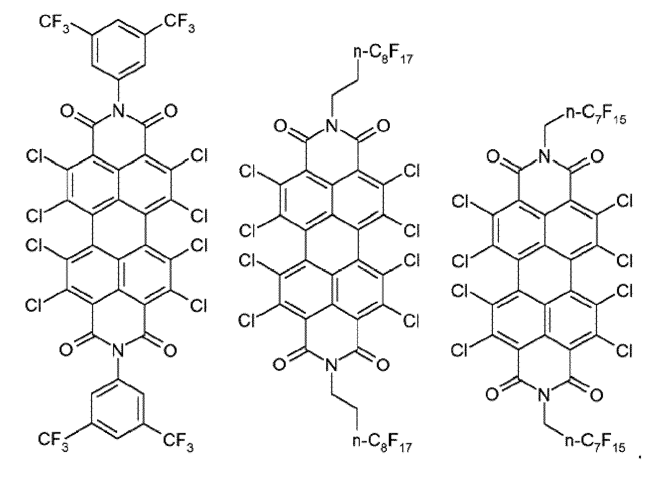

5. Utilisation de composés de formules générales (I.A), (IBa), (I.Bb1) ou (I.Bb2), tels que définis dans l'une des revendications 1 à 4, en tant que conducteurs d'électrons dans des transistors à effet de champ organiques, des cellules solaires organiques et dans des diodes électroluminescentes organiques.

6. Utilisation selon la revendication 5 en tant que matériaux semi-conducteurs dans des transistors à effet de champ organiques.

7. Utilisation de composés de formules générales (I.A), (I.Ba), (I.Bb1) ou (I.Bb2), tels que définis dans l'une des revendications 1 à 4, en tant que matière active en photovoltaïque organique, en particulier en tant que matériaux de transport d'excitons dans les cellules solaires à excitons.

8. Utilisation d'un composé de formules générales (I.A), (I.Ba), (I.Bb1) ou (I.Bb2) tel que défini dans l'une des revendications 1 à 4 pour des marqueurs optiques, pour le marquage invisible de produits, en tant que colorants fluorescents, en tant que marqueurs fluorescents pour biomolécules et en tant que pigments.

9. Utilisation d'un composé de formules générales (I.A), (I.Ba), (I.Bb1) ou (I.Bb2) tel que défini dans l'une des revendications 1 à 4, en tant que colorant fluorescent dans un affichage se fondant sur une conversion de fluorescence, dans une pièce plastique collectrice de lumière, qui est éventuellement combinée à une cellule solaire ; en tant que colorant pigmentaire dans des affichages électrophorétiques ; en tant que colorant fluorescent dans une application se fondant sur la chimioluminescence.

10. Composés de formule (I.A) 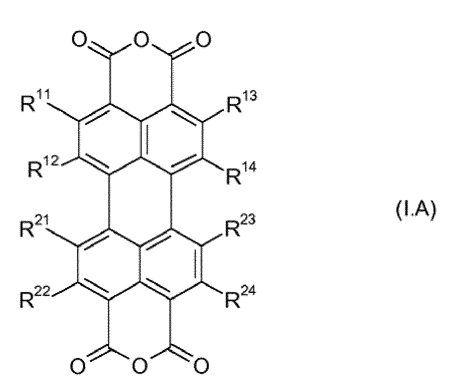 dans laquelle R¹¹, R¹², R¹³, R¹⁴, R²¹, R²², R²³ et R²⁴ représentent tous le groupe fluoro.

11. Composés de formule (I.Ba) 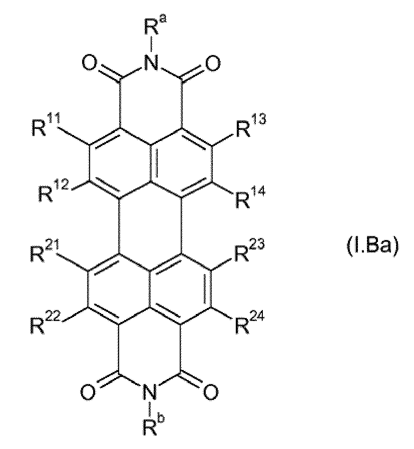 dans laquelle R^{a}, R^{b}, R¹¹, R¹², R¹³ R¹⁴, R²¹, R²², R²³ et R²⁴ ont chacun l'une des significations données dans la revendication 1.

12. Composés de formules (I.Bb1) et (I.Bb2) 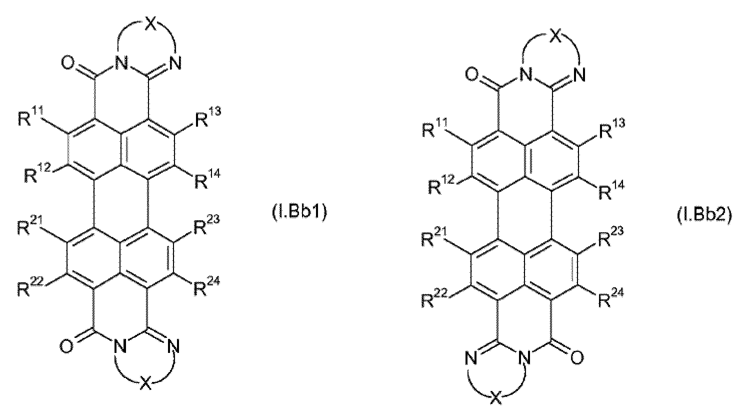 dans lesquelles R¹¹, R¹², R¹³, R¹⁴, R²¹, R²², R²³, R²⁴ et X ont chacun l'une des significations données dans la revendication 1.

13. Transistor à effet de champ organique, comprenant un substrat ayant au moins une structure de grille, une électrode source et une électrode drain et au moins un composé de formule (I.A), (I.Ba), (I.Bb1) ou (I.Bb2), tel que défini dans l'une des revendications 1 à 4, en tant que semi-conducteur n.

14. Cellule solaire organique comprenant au moins un composé de formules (I.A), (I.Ba), (I.Bb1) ou (I.Bb2), tel que défini dans l'une des revendications 1 à 4.

15. OLED comprenant au moins un composé de formules (I.A), (I.Ba), (I.Bb1) ou (I.Bb2), tel que défini dans l'une des revendications 1 à 4.

16. Substrat comprenant un grand nombre de transistors à effet de champ organiques, dans lequel au moins une partie des transistors à effet de champ contiennent en tant que semi-conducteur n au moins un composé de formule (I.A), (I.Ba), (I.Bb1) ou (I.Bb2), tel que défini dans l'une des revendications 1 à 4.
